(19) Europäisches Patentamt
European Patent Office
Office européen des brevets

(11) **EP 2 539 980 B1**

(12) **EUROPÄISCHE PATENTSCHRIFT**

(45) Veröffentlichungstag und Bekanntmachung des Hinweises auf die Patenterteilung:
**11.04.2018 Patentblatt 2018/15**

(21) Anmeldenummer: **11704791.0**

(22) Anmeldetag: **23.02.2011**

(51) Int Cl.:
*H01S 5/343* (2006.01)   *H01S 5/20* (2006.01)

(86) Internationale Anmeldenummer:
**PCT/EP2011/052681**

(87) Internationale Veröffentlichungsnummer:
**WO 2011/104274 (01.09.2011 Gazette 2011/35)**

(54) **OPTOELEKTRONISCHER HALBLEITERCHIP**

OPTOELECTRONIC SEMICONDUCTOR CHIP

PUCE SEMI-CONDUCTRICE OPTOÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.02.2010 DE 102010009457**

(43) Veröffentlichungstag der Anmeldung:
**02.01.2013 Patentblatt 2013/01**

(73) Patentinhaber: **OSRAM Opto Semiconductors GmbH**
**93055 Regensburg (DE)**

(72) Erfinder:
• **EICHLER, Christoph**
**93105 Tegernheim (DE)**
• **LERMER, Teresa**
**93053 Regensburg (DE)**
• **AVRAMESCU, Adrian Stefan**
**93051 Regensburg (DE)**

(74) Vertreter: **Epping - Hermann - Fischer Patentanwaltsgesellschaft mbH**
**Postfach 20 07 34**
**80007 München (DE)**

(56) Entgegenhaltungen:
EP-A2- 1 411 559       JP-A- 2000 277 862
US-A1- 2001 038 656    US-A1- 2002 039 374
US-A1- 2003 147 440    US-A1- 2005 226 295
US-A1- 2007 183 469

• M. BUDA ET AL: "Waveguiding in InGaN/GaN/AlGaN blue lasers", COMMAD 2000 PROCEEDINGS. CONFERENCE ON OPTOELECTRONIC AMD MICROELECTRONIC MATERIALS AND DEVICES. BUNDOORA, VIC., AUSTRALIA, 6. Dezember 2000 (2000-12-06), - 8. Dezember 2000 (2000-12-08), Seiten 438-442, XP002659509, IEEE Piscataway, NJ, USA DOI: 10.1109/COMMAD.2000.1022984 ISBN: 0-7803-6698-0
• XIAOMIN JIN ET AL: "Mode pattern analysis of gallium nitride based laser diodes", INTERNATIONAL SYMPOSIUM ON PHOTOELECTRONIC DETECTION AND IMAGING 2009: LASER SENSING AND IMAGING. BEIJING, CHINA, Bd. 7382, 73820O, 17. Juni 2009 (2009-06-17), - 19. Juni 2009 (2009-06-19), Seiten 1-12, XP002659510, Proceedings of the SPIE - The International Society for Optical Engineering SPIE - USA ISSN: 0277-786X, DOI: 10.1117/12.834103

**Beschreibung**

Es wird ein optoelektronischer Halbleiterchip angegeben.

Die Druckschrift US 2005/0226295 A1 betrifft eine Halbleiterlaserdiode.

In der Druckschrift US 2002/0039374 A1 ist eine Halbleiterlaserdiode beschrieben.

Eine zu lösende Aufgabe besteht darin, einen optoelektronischen Halbleiterchip anzugeben, bei dem ein Träger einer Halbleiterschichtenfolge nicht als parasitärer Wellenleiter wirkt.

Diese Aufgabe wird durch einen optoelektronische Halbleiterchip mit den Merkmalen des unabhängigen Patentanspruchs gelöst. Bevorzugte Weiterbildungen sind Gegenstand der abhängigen Ansprüche.

Der optoelektronische Halbleiterchip umfasst einen Träger und eine auf dem Träger angebrachte Halbleiterschichtenfolge. Bei dem Träger kann es sich insbesondere um ein Aufwachssubstrat handeln, auf dem die Halbleiterschichtenfolge epitaktisch aufgewachsen ist.

Es basiert die Halbleiterschichtenfolge auf einem Nitrid-Verbindungshalbleitermaterial. Dies bedeutet im vorliegenden Zusammenhang, dass die Halbleiterschichtenfolge oder zumindest ein Teil davon, besonders bevorzugt zumindest eine aktive Zone und/oder ein Aufwachssubstrat wie der Träger ein Nitrid-Verbindungshalbleitermaterial, vorzugsweise $Al_nGa_mIn_{1-n-m}N$ aufweist oder aus diesem besteht, wobei $0 \leq n \leq 1$, $0 \leq m \leq 1$ und $n + m \leq 1$. Dabei muss dieses Material nicht zwingend eine mathematisch exakte Zusammensetzung nach obiger Formel aufweisen. Vielmehr kann es beispielsweise ein oder mehrere Dotierstoffe sowie zusätzliche Bestandteile aufweisen. Der Einfachheit halber beinhaltet obige Formel jedoch nur die wesentlichen Bestandteile des Kristallgitters, also Al, Ga, In und N, auch wenn diese teilweise durch geringe Mengen weiterer Stoffe ersetzt und/oder ergänzt sein können.

Es umfasst die Halbleiterschichtenfolge eine aktive Zone, die zur Erzeugung einer elektromagnetischen Strahlung vorgesehen ist. Die aktive Zone umfasst bevorzugt mindestens einen pn-Übergang oder zwischen einschließlich ein und zehn Quantenfilme, besonders bevorzugt zwischen einschließlich ein und fünf Quantenfilme oder zwischen einschließlich ein und drei Quantenfilme. Die Bezeichnung Quantenfilm umfasst insbesondere Quantentopfstrukturen unabhängig von der Dimensionalität der Quantisierung. Bevorzugt beinhalten die Quantenfilme InGaN. Eine Wellenlänge der im Betrieb erzeugten Strahlung liegt insbesondere im ultravioletten oder im sichtbaren Spektralbereich, beispielsweise zwischen einschließlich 340 nm und 600 nm, insbesondere zwischen einschließlich 390 nm und 540 nm. Die in der aktiven Zone erzeugte elektromagnetische Strahlung ist bevorzugt eine kohärente Strahlung, also eine Laserstrahlung. Mit anderen Worten kann der Halbleiterchip ein Laserdiodenchip sein. Die aktive Zone ist also ein Bereich, in dem eine optische Verstärkung auftritt. Ein Imaginärteil des Brechungsindexes der aktiven Zone kann kleiner als null sein.

Gemäß zumindest einer Ausführungsform des Halbleiterchips liegt ein mittlerer Indiumgehalt der aktiven Zone zwischen einschließlich 0,5 % und 15 %. Hierbei werden insbesondere alle Indium-haltigen Schichten von bis zu 300 nm symmetrisch um einen zentral gelegenen, Licht erzeugenden Bereich der aktiven Zone berücksichtigt.

Gemäß zumindest einer Ausführungsform des Halbleiterchips befinden sich zumindest zwischen zwei der benachbarten Quantenfilme, insbesondere zwischen allen benachbarten Quantenfilmen, Barriereschichten, bevorzugt basierend auf InGaN. Diese Barriereschichten weisen insbesondere einen Indiumgehalt zwischen einschließlich 0,01 % und 20 %, bevorzugt zwischen einschließlich 0,01 % und 10 % auf. Schichtdicken der Barriereschichten zwischen den Quantenfilmen der aktiven Zone 4 liegen insbesondere zwischen einschließlich 0,1 nm und 30 nm, bevorzugt zwischen einschließlich 0,1 nm und 15 nm, besonders bevorzugt zwischen einschließlich 1 nm und 10 nm.

Es umfasst die Halbleiterschichtenfolge wenigstens eine Wellenleiterschicht. Bevorzugt beinhaltet die Halbleiterschichtenfolge zwei Wellenleiterschichten, zwischen denen sich die aktive Zone befindet. Die Wellenleiterschichten sind insbesondere solche Schichten, die mittelbar oder unmittelbar an die aktive Zone grenzen und die einen Brechungsindex aufweisen, der größer oder gleich dem Brechungsindex des Trägers ist.

Es wird durch die mindestens eine Wellenleiterschicht und durch die aktive Zone ein Wellenleiter gebildet, in dem eine optische Mode geführt wird. Der Wellenleiter kann ein zweidimensionaler oder ein eindimensionaler Wellenleiter sein. Im Falle eines zweidimensionalen Wellenleiters wird die in der aktiven Zone erzeugte Strahlung in einer Ebene geführt, im Falle eines eindimensionalen Wellenleiters entlang einer Linie. Bei der geführten Mode handelt es sich bevorzugt um eine Grundmode, zum Beispiel um die so genannte $TEM_{00}$. Bevorzugt ist der Wellenleiter derart gestaltet, dass im bestimmungsgemäßen Gebrauch des Halbleiterchips in dem Wellenleiter ausschließlich die Grundmode geführt wird.

Es grenzt an die Wellenleiterschicht oder grenzen an zwei der Wellenleiterschichten Mantelschichten. Die Mantelschichten befinden sich jeweils an einer der aktiven Zone abgewandten Seite der Wellenleiterschicht oder der Wellenleiterschichten. Die Mantelschichten sind p-dotiert bzw. n-dotiert. Mantelschichten sind solche Schichten, die mittelbar oder unmittelbar an die Wellenleiterschichten grenzen, wobei ein Brechungsindex der Mantelschichten kleiner ist als ein Brechungsindex des Trägers und somit auch kleiner als ein Brechungsindex der Wellenleiterschichten.

Gemäß zumindest einer Ausführungsform des Halbleiterchips beginnen die Mantelschichten in der Halbleiterschichtenfolge, gesehen in einer Richtung weg von einer geometrischen Mitte der aktiven Zone, dort, wo ein Aluminiumgehalt erstmals größer als Null oder größer als 0,01 % oder größer als 0,1 % oder größer als 1 % ist. Sind innerhalb des Wellenleiters Barriereschichten untergebracht, so zählen diese Barriereschichten, die typisch eine Dicke von höchstens 50 nm aufweisen, bei der Bestimmung des Beginns der Mantelschichten bevorzugt nicht mit. Zum Beispiel ist ein Beginn der Mantelschichten, in Richtung weg von der Mitte der aktiven Zone, ein Teilbereich der Halbleiterschichtenfolge mit einer Dicke von mindestens 100 nm und einem durchgehenden, nicht verschwindenden Aluminiumgehalt. Die Mantelschicht kann auch bei einem Übergitter, englisch Superlattice, beginnen, das beispielsweise durch abwechselnde Schichten mit AlGaN/GaN oder AlGaN/AlGaN oder AlInGaN/GaN gebildet ist, wobei Einzelschichten des Übergitters eine Dicke von bevorzugt höchstens 20 nm oder höchstens 10 nm oder höchstens 5 nm aufweisen und das Übergitter insbesondere eine Dicke von mindestens 100 nm oder mindestens 200 nm aufweist.

Es ist ein effektiver Brechungsindex der im Wellenleiter geführten Mode größer als ein Brechungsindex des Trägers. Insbesondere beträgt der effektive Brechungsindex höchstens ein 1,05-faches des Brechungsindexes des Trägers.

Der effektive Brechungsindex ist hierbei eine Zahl, die eine Phasenverzögerung pro Längeneinheit in dem Wellenleiter quantifiziert, relativ zu einer Phasenverzögerung im Vakuum. Im Englischen wird die Phasenverzögerung auch als phase delay bezeichnet. Der effektive Brechungsindex ist abhängig von der geführten Mode. So ist im Regelfall ein effektiver Brechungsindex der Grundmode von einem effektiven Brechungsindex einer höheren Mode verschieden, auch bei gleicher Wellenlänge. Weiterhin ist der effektive Brechungsindex von einer Ausbreitungskonstante $\beta$, englisch propagation constant, abhängig. Die Ausbreitungskonstante ist über den folgenden Zusammenhang gegeben:

$$\vec{E}\,(x,\ y,\ z,\ t)\ =\ \vec{E}_0\,(x,\ y)\ e^{i(\beta z\ -\ \omega t)}.$$

$\vec{E}$ ist hierbei die elektrische Feldstärke, z ist eine Propagationsrichtung oder Führungsrichtung in dem Wellenleiter, $\omega$ ist die Frequenz der Strahlung und t ist die Zeit. Die Ausbreitungskonstante ist ebenfalls abhängig von der geführten Mode und ist somit etwa für die Grundmode und für höhere Moden verschieden. Die Ausbreitungskonstante ist durch Programme zur Optiksimulation bestimmbar oder kann auch zum Beispiel interferometrisch experimentell ermittelt werden. Durch die Ausbreitungskonstante wird also eine Phasenänderung für Licht, das sich in einem Medium und insbesondere in einem Wellenleiter ausbreitet, bezogen auf eine Längeneinheit angegeben.

Für den effektiven Brechungsindex $n_{eff}$ des Wellenleiters gilt dann der Zusammenhang:

$$n_{eff}\ =\ \frac{\beta\lambda}{2\pi}$$

Für den effektiven Brechungsindex $n_{eff}$ einer geführten Mode in einem Wellenleiter gilt bevorzugt, dass der effektive Brechungsindex kleiner ist als der Brechungsindex oder der mittlere Brechungsindex des Wellenleiters und dass der effektive Brechungsindex größer oder gleich dem Brechungsindex oder mittlerem Brechungsindex der Mantelschicht ist. Mit anderen Worten liegt der effektive Brechungsindex für eine geführte Mode zwischen dem Brechungsindex der Mantelschicht und dem Brechungsindex oder dem mittleren Brechungsindex des Wellenleiters. Ist diese Bedingung nicht erfüllt, wird die Mode im Regelfall nicht geführt beziehungsweise es treten bei der Führung der Mode optische Verluste auf.

Erfindungsgemäß umfasst der optoelektronische Halbleiterchip einen Träger und eine auf dem Träger angebrachte, insbesondere aufgewachsene Halbleiterschichtenfolge. Die Halbleiterschichtenfolge basiert auf einem Nitrid-Verbindungshalbleitermaterial und beinhaltet wenigstens eine aktive Zone zur Erzeugung einer elektromagnetischen Strahlung sowie wenigstens eine Wellenleiterschicht, die mittelbar oder unmittelbar an die aktive Zone grenzt, wobei ein Wellenleiter gebildet ist. Außerdem umfasst die Halbleiterschichtenfolge eine an die Wellenleiterschicht grenzende p-Mantelschicht an einer p-dotierten Seite oder/und eine n-Mantelschicht an einer n-dotierten Seite der aktiven Zone. Die Wellenleiterschicht grenzt mittelbar oder unmittelbar an die Mantelschicht. Ein effektiver Brechungsindex einer im Wellenleiter geführten Mode ist hierbei größer als ein Brechungsindex des Trägers.

Dem angegebenen Halbleiterchip liegt also insbesondere die Erkenntnis zugrunde, eine Kombination von Schichten mit niedrigem Brechungsindex und mit hohem Brechungsindex auf dem Träger, insbesondere einem Aufwachssubstrat, in genau der Art aufzubringen, dass ein Wellenleiter gebildet wird, in dem eine Mode geführt wird, wobei ein effektiver Brechungsindex für die geführte Mode größer ist als der Brechungsindex des Trägers. Bei dem beschriebenen Halbleiterchip ist es nicht notwendig, dass ein evaneszentes Feld, das bei einer Totalreflexion an der Grenzfläche insbesondere zwischen Wellenleiter und Mantelschicht auftritt und in die Mantelschicht reicht, an einem Eindringen in den transparenten Träger gehindert wird. Das evaneszente Feld dringt also in den Träger ein. Es weist das evaneszente Feld in dem Träger stellenweise eine vergleichsweise hohe Amplitude von mindestens $1/e^3$ oder von mindestens 5 % oder von mindestens 2,5 % auf, bezogen auf eine Ausgangsamplitude des Feldes an einer Grenzfläche, an der die Totalreflexion stattfindet. Bei herkömmlichen Laserchips wird dieses Eindringen des evaneszenten Feldes in den Träger im Regelfall unterbunden, insbesondere durch besonders dicke Mantelschichten. Da gemäß dem angegebenen Halbleiterchip der Brechungsindex des Trägers kleiner ist als der effektive Brechungsindex der geführten Mode kann sich in dem Träger jedoch keine parasitäre Mode ausbilden, obwohl das evaneszente Feld in den Träger eindringen kann.

Eine parasitäre Mode in dem Träger äußert sich insbesondere als zusätzliche Bande in einem optischen Fernfeld, zum Beispiel bei zirka 20 °. Solche Banden treten insbesondere an der dem Träger zugewandten Seite der aktiven Zone auf. Diese zusätzlichen Banden verschlechtern eine Strahlqualität des bevorzugt als Laser ausgeführten Halbleiterchips. Dies wirkt zum Beispiel bei Anwendungen in der Datenspeicherung als auch bei Anwendungen zur Projektion als störend. Dadurch, dass verhindert wird, dass sich eine Mode in dem Träger etabliert, ist diese Problematik vermeidbar.

Gemäß zumindest einer Ausführungsform des Halbleiterchips basiert die n-Mantelschicht auf AlGaN mit einem Al-Anteil zwischen einschließlich 0,1 % und 20 % oder auf AlInN oder AlInGaN . Insbesondere besteht oder basiert die n-Mantelschicht auf $Al_xGa_{1-x}N$ mit $0,0001 \leq x \leq 0,30$, auf $Al_xIn_{1-x}N$ mit $0,0001 \leq x \leq 0,90$ oder auf $(Al_{1-y}In_y)_xGa_{1-x}N$ mit $0,74 \leq y \leq 0,90$ und $0,01 \leq x \leq 0,3$.

Gemäß zumindest einer Ausführungsform des Halbleiterchips ist eine Elektronenbarriereschicht zwischen der p-Mantelschicht und dem Wellenleiter angeordnet und/oder eine Löcherbarriereschicht zwischen der n-Mantelschicht und dem Wellenleiter. Solche Barriereschichten können auch innerhalb des Wellenleiters angeordnet sein.

Gemäß zumindest einer Ausführungsform des Halbleiterchips beinhaltet der Wellenleiter zu einer Verbesserung der Wellenführung zwischen wenigstens zwei der benachbarten Quantenfilme eine auf InGaN basierende Barriereschicht mit einem In-Anteil zwischen einschließlich 0,1 % und 20 % und einer Dicke zwischen einschließlich 0,1 nm und 30 nm. Durch die Barriereschichten zwischen den Quantenfilmen ist es möglich, ein Übergitter zu formen.

Gemäß zumindest einer Ausführungsform des Halbleiterchips weist die Wellenleiterschicht ein Übergitter mit Schichten mit abwechselnd hohem und niedrigem Brechungsindex auf, wobei Dicken der Schichten jeweils zwischen einschließlich 0,1 nm und 70 nm oder zwischen einschließlich 1 nm und 50 nm betragen. Die Schichten basieren zum Beispiel auf GaN oder auf InGaN mit einem In-Anteil von bis zu 25 %.

Gemäß zumindest einer Ausführungsform des Halbleiterchips weist die Mantelschicht ein Übergitter mit Schichten mit abwechselnd hohem und niedrigem Brechungsindex auf, wobei Dicken der Schichten jeweils zwischen einschließlich 0,1 nm und 70 nm betragen. Im Falle einer p-Mantelschicht liegen die Dicken der Schichten bevorzugt zwischen einschließlich 1 nm und 70 nm. Die Schichten basieren zum Beispiel auf GaN oder auf AlGaN mit einem Al-Anteil von bis zu 25 %.

Gemäß zumindest einer Ausführungsform des optoelektronischen Halbleiterchips ist die Wellenleiterschicht oder wenigstens eine der Wellenleiterschichten und/oder die Mantelschicht oder wenigstens eine der Mantelschichten mit einem gestuften Brechungsindexverlauf gebildet. Mit anderen Worten ist der Brechungsindex innerhalb der entsprechenden Schicht nicht konstant, sondern gezielt variiert. Insbesondere nimmt der Brechungsindex der entsprechenden Schichten, in eine Richtung weg von der aktiven Zone, monoton ab.

Gemäß zumindest einer Ausführungsform des optoelektronischen Halbleiterchips ist wenigstens eine der Mantelschichten, bevorzugt die dem Träger nächstgelegene Mantelschicht, in mindestens zwei Teilschichten aufgeteilt. Zwischen benachbarten Teilschichten befindet sich insbesondere ein Material, das einen Brechungsindex aufweist, der ungefähr dem Brechungsindex des Trägers entspricht. Bevorzugt ist die Mantelschicht in 2 bis 10 Teilschichten unterteilt, die in eine Richtung weg von der aktiven Zone eine monoton ansteigende Dicke aufweisen können.

Gemäß zumindest einer Ausführungsform des Halbleiterchips weist wenigstens eine der Mantelschichten, also die n-Mantelschicht und/oder die p-Mantelschicht, entlang einer Wachstumsrichtung der Halbleiterschichtenfolge und/oder entlang einer Richtung senkrecht zum Träger, einen stufenförmigen oder einen rampenförmigen Verlauf des Aluminiumgehalts auf. Stufenförmig bedeutet, dass der Aluminiumgehalt innerhalb einer Stufe konstant oder näherungsweise konstant ist. Rampenförmig bedeutet, dass sich der Aluminiumgehalt linear oder näherungsweise linear entlang der Wachstumsrichtung und/oder in der Richtung senkrecht zum Träger ändert. Zum Beispiel weist die Mantelschicht 2, 3, 4, 5 oder 6 oder bis zu 15 Stufen und/oder Rampen auf. Ein Unterschied im Aluminiumgehalt von benachbarten Stufen liegt insbesondere zwischen einschließlich 0,01 Prozentpunkte und 20 Prozentpunkte oder zwischen einschließlich 0,5 Prozentpunkte und 10 Prozentpunkte oder zwischen einschließlich 1 Prozentpunkt und 5 Prozentpunkte.

Es gilt, dass der mittlere Aluminiumgehalt einer ersten Hälfte der Mantelschicht größer ist als der mittlere Aluminiumgehalt in einer zweiten Hälfte der Mantelschicht. Die erste und die zweite Hälfte weisen die gleiche geometrische Dicke auf. Es können die beiden Hälften eine lediglich fiktive Unterteilung der Mantelschicht in zwei gleich Dicke Teilbereiche darstellen. Die erste Hälfte liegt näher an dem Wellenleiter mit der aktiven Zone als die zweite Hälfte.

Es übersteigt der mittlere Aluminiumgehalt der ersten Hälfte den der zweiten Hälfte um mindestens 0,1 Prozentpunkte oder um mindestens 0,5 Prozentpunkte. Bevorzugt beträgt der Unterschied im mittleren Aluminiumgehalt höchstens 15 Prozentpunkte oder höchstens 10 Prozentpunkte oder höchstens 5 Prozentpunkte.

Gemäß zumindest einer Ausführungsform des Halbleiterchips beträgt der Aluminiumgehalt von einer oder von beiden Mantelschichten in einem dem Wellenleiter am nächsten gelegenen Bereich mindestens 0,5 %, bevorzugt mindestens 1 %.

Gemäß zumindest einer Ausführungsform des Halbleiterchips ist eine oder sind beide Mantelschichten dünn ausgebildet. Dünn kann bedeuten, dass die Dicke der Mantelschicht höchstens 500 nm beträgt. Bevorzugt beträgt die Dicke hierbei mindestens 200 nm oder mindestens 300 nm.

Gemäß zumindest einer Ausführungsform des Halbleiterchips beträgt der mittlere Aluminiumgehalt einer oder beider Mantelschichten zwischen einschließlich 0,1 % und 30 % oder zwischen einschließlich 1 % und 12 % oder zwischen einschließlich 3 % und 8 %. Es ist möglich, dass auch der lokale Aluminiumgehalt innerhalb der gesamten Mantelschicht die genannten Wertebereiche nicht verlässt. Die genannten Werte gelten insbesondere bei dünnen Mantelschichten.

Gemäß zumindest einer Ausführungsform des Halbleiterchips weist der optische Brechungsindex in mindestens einer oder in beiden Mantelschichten einen stufenförmigen oder rampenförmigen Verlauf auf. Die zwei gleich dicken, fiktiven Hälften der Mantelschicht weisen verschiedene mittlere, optische Brechungsindices auf. Die dem Wellenleiter nähere erste Hälfte weist einen niedrigeren mittleren Brechungsindex auf als die zweite Hälfte. Der Brechungsindexunterschied zwischen den Hälften liegt bevorzugt zwischen einschließlich 0,0001 und 0,2 oder zwischen einschließlich 0,001 und 0,08 oder zwischen einschließlich 0,001 und 0,03.

Im Falle eines stufenförmigen Verlaufs liegen die Brechungsindexunterschiede zwischen benachbarten Stufen bevorzugt zwischen einschließlich 0,0001 und 0,2 oder zwischen einschließlich 0,001 und 0,1 oder zwischen einschließlich 0,002 und 0,03.

Gemäß zumindest einer Ausführungsform des Halbleiterchips besteht die p-Mantelschicht aus InGaAlN, wobei das InGaAlN dotiert sein kann. Eine Dicke der p-Mantelschicht liegt zwischen einschließlich 100 nm und 5000 nm, bevorzugt zwischen einschließlich 200 nm und 2000 nm oder zwischen einschließlich 400 nm und 900 nm. Der mittlere Aluminiumgehalt der p-Mantelschicht liegt zwischen einschließlich 0,1 % und 20 % oder zwischen einschließlich 3 % und 10 % oder zwischen einschließlich 4 % und 8 %.

Gemäß zumindest einer Ausführungsform des Halbleiterchips liegt eine Gesamtdicke des Wellenleiters, also insbesondere ein Abstand zwischen der p-Mantelschicht und der n-Mantelschicht, zwischen einschließlich 50 nm und 2000 nm oder zwischen einschließlich 200 nm und 1200 nm oder zwischen einschließlich 400 nm und 800 nm.

Gemäß zumindest einer Ausführungsform des optoelektronischen Halbleiterchips ist dieser eine Laserchip mit einer oder mit mehreren separaten oder zusammenhängenden laseraktiven Bereichen, ein Ridge-Laser, ein Oxidstreifenlaser, ein Laserbarren oder eine Leuchtdiode.

Die genannten Ausführungsbeispiele können untereinander kombiniert werden, sofern sich hieraus keine Widersprüche ergeben. Insbesondere ist der optoelektronische Halbleiterchip gemäß mehreren der genannten Ausführungsbeispiele ausgebildet.

Nachfolgend wird ein hier beschriebener optoelektronischer Halbleiterchip unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:

Figuren 4 bis 7, 10 bis 14, 16 bis 18, 20, 23 und 24 schematische Darstellungen von Ausführungsbeispielen von hier beschriebenen optoelektronischen Halbleiterchips, und

Figuren 1 bis 3, 8, 9, 15, 19, 21 und 22 schematische Darstellungen von Laserdioden, und

Figuren 23, 24 schematische Darstellungen von Laserdioden gemäß der Erfindung.

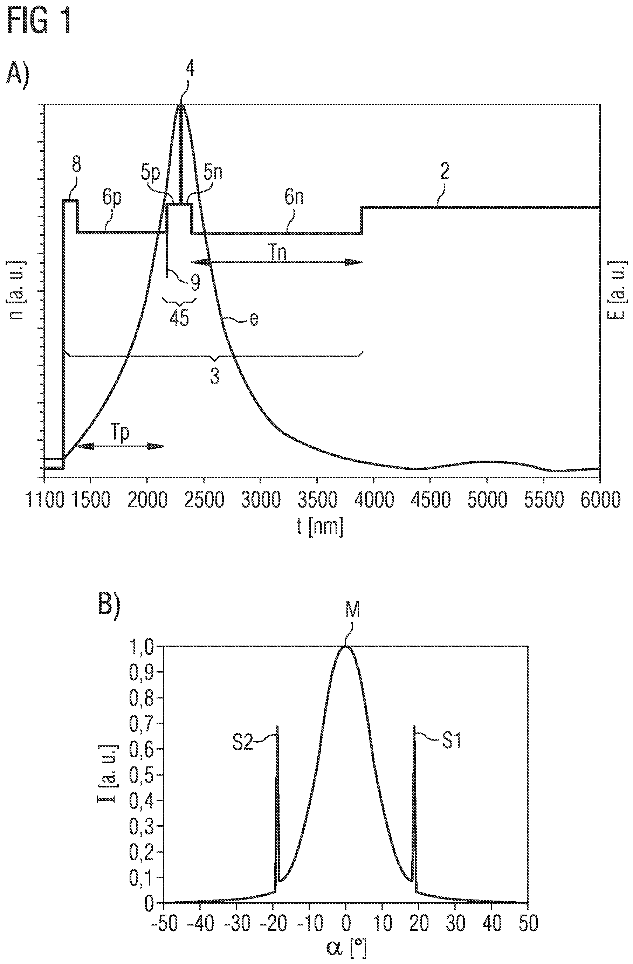

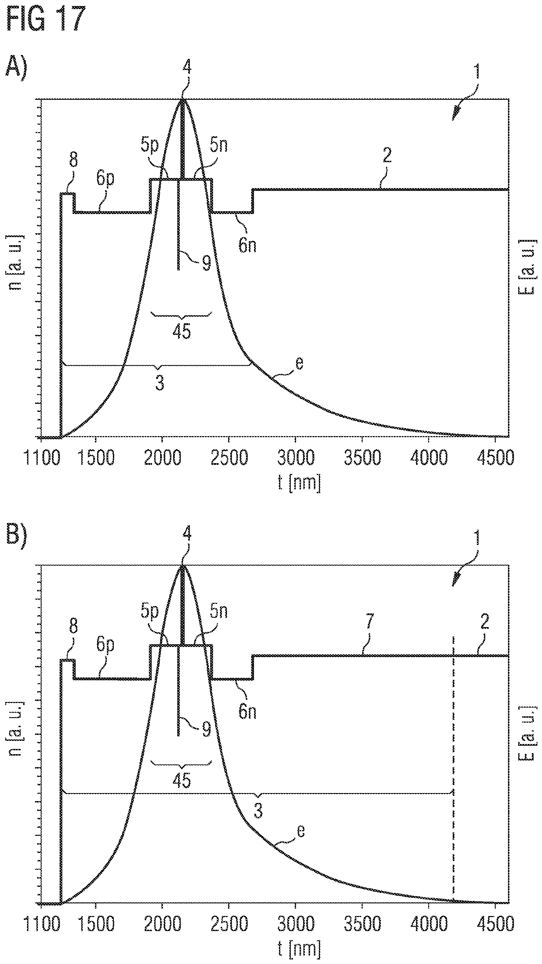

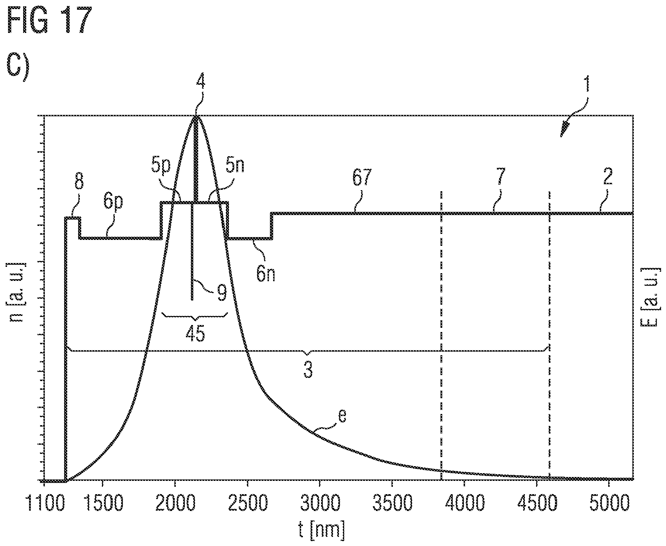

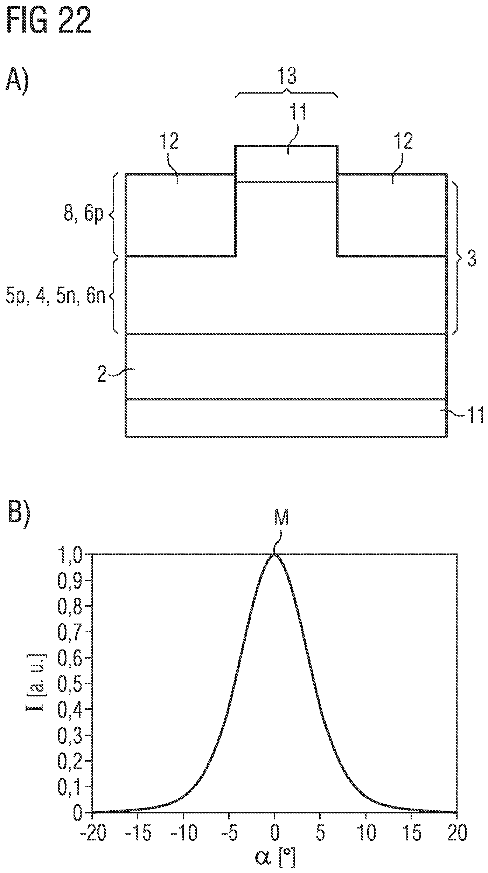

Mit Ausnahme von Figuren 17 und 22 ist in den A-Teilen der Figuren jeweils ein Brechungsindexverlauf entlang einer Tiefe t, die parallel zu einer Wachstumsrichtung der Halbleiterschichtenfolge orientiert ist, in willkürlichen Einheiten aufgetragen. Ebenfalls ist in den A-Figuren ein Verlauf e eines elektrischen Feldes E entlang der Tiefe t in willkürlichen Einheiten aufgetragen. In den B-Figuren ist eine Intensität I eines optischen Fernfeldes in willkürlichen Einheiten gegenüber einem Abstrahlwinkel $\alpha$, angegeben in Grad, aufgetragen. Die Figuren 17A, 17B und 17C entsprechen in der Darstellung jeweils den A-Teilen der anderen Figuren. In Figur 1 ist der Aufbau einer herkömmlichen Laserdiode illustriert. Eine Halbleiterschichtenfolge 3 ist auf einem Träger 2 aufgewachsen. Die Halbleiterschichtenfolge 3 umfasst eine aktive Zone 4 mit Quantenfilmen, in den Figuren gekennzeichnet durch einen Bereich mit erhöhtem Brechungsindex. Die aktive Zone 4 befindet sich zwischen zwei Wellenleiterschichten 5n, 5p, die unmittelbar an die aktive Zone 4 grenzen. Die Wellenleiterschicht 5n in Richtung hin zu dem Träger 2, von der aktiven Zone 4 aus gesehen, ist n-dotiert, die andere Mantelschicht 5p ist p-dotiert. Durch die aktive Zone 4 sowie durch die Mantelschichten 5n, 5p ist ein Wellenleiter 45 gebildet, in dem eine optische Mode M geführt ist. Die Mode M wird bei einem Abstrahlwinkel $\alpha$ von zirka 0 ° emittiert, also senkrecht zu einer lateralen Begrenzungsfläche der Halbleiterschichtenfolge 3.

Von der aktiven Zone 4 weg hin zum Träger 2 schließt sich an die n-Wellenleiterschicht 5n eine n-dotierte n-Mantelschicht 6n an. In eine Richtung weg von dem Träger 2, ausgehend von der aktiven Zone 4, schließt sich an die p-Wellenleiterschicht 5p eine Elektronenbarriere 9 sowie eine p-dotierte p-Mantelschicht 6p an, gefolgt von einer Kontaktschicht 8. Die Brechungsindices der Mantelschichten 6n, 6p sind kleiner als ein Brechungsindex des Trägers 2.

Eine Dicke Tn der n-Mantelschicht 6n beträgt zirka 1500 nm. Eine Dicke Tp der p-Mantelschicht 6p beträgt zirka 800 nm. Aufgrund der vergleichsweise geringen Dicke Tn der n-Mantelschicht 6n ist ein evaneszentes Feld innerhalb der Mantelschicht 6n noch nicht abgeklungen und dringt in den transparenten Träger 2 ein. Da ein effektiver Brechungsindex für die geführte Mode M im Wellenleiter 45 kleiner ist als der Brechungsindex des Trägers 2, kann sich ein elektrisches Feld in dem Träger 2 aufbauen, vergleiche den Anstieg im Verlauf e des elektrischen Feldes E in Figur 1A bei zirka 5000 nm. Dieses elektrische Feld im Träger 2 äußert sich im optischen Fernfeld als eine zusätzliche Bande S1 bei einem Winkel $\alpha$ von zirka 20 °. Ebenso kann bei einem Winkel von -20 ° eine weitere parasitäre Mode S2 auftreten. Durch diese eine oder diese zwei zusätzlichen, parasitären Moden S1, S2 entstehen Schwierigkeiten bei einer Projektionsanwendung oder Datenspeicherungsanwendung des Laserchips gemäß Figur 1A.

Der effektive Brechungsindex der geführten Mode M ist gleich dem Produkt aus der Ausbreitungskonstanten $\beta$ und der Wellenlänge $\lambda$ der Strahlung, dividiert durch $2\pi$. Die Ausbreitungskonstante $\beta$ ist abhängig von der Ordnung der geführten Mode, insbesondere also von einer Verteilung des elektrischen Feldes in einer Ebene senkrecht zu einer Ausbreitungsrichtung der Strahlung, entlang derer der Wellenleiter das Feld führt. Die Feldverteilung senkrecht zur Ausbreitungsrichtung ist wiederum abhängig vom Brechungsindex und von der Dicke der Mantelschichten 6n, 6p sowie vom Brechungsindex und der Struktur des Wellenleiters 45.

Insbesondere ist also bei einem vorgegebenen Wellenleiter 45, speziell mit einer vorgegebenen aktiven Zone 4, das elektrische Feld senkrecht zur Ausbreitungsrichtung und somit die Ausbreitungskonstante $\beta$ der in dem Wellenleiter 45 geführten Mode durch einen Brechungsindex der Mantelschichten 6n, 6p und durch deren Dicke beeinflussbar. Die Ausbreitungskonstante $\beta$ sowie das elektrische Feld senkrecht zu einer Ausbreitungsrichtung sind berechenbar beziehungsweise simulierbar. Ebenso kann das elektrische Feld beziehungsweise das Quadrat des elektrischen Feldes, die Intensitätsverteilung, experimentell bestimmt werden.

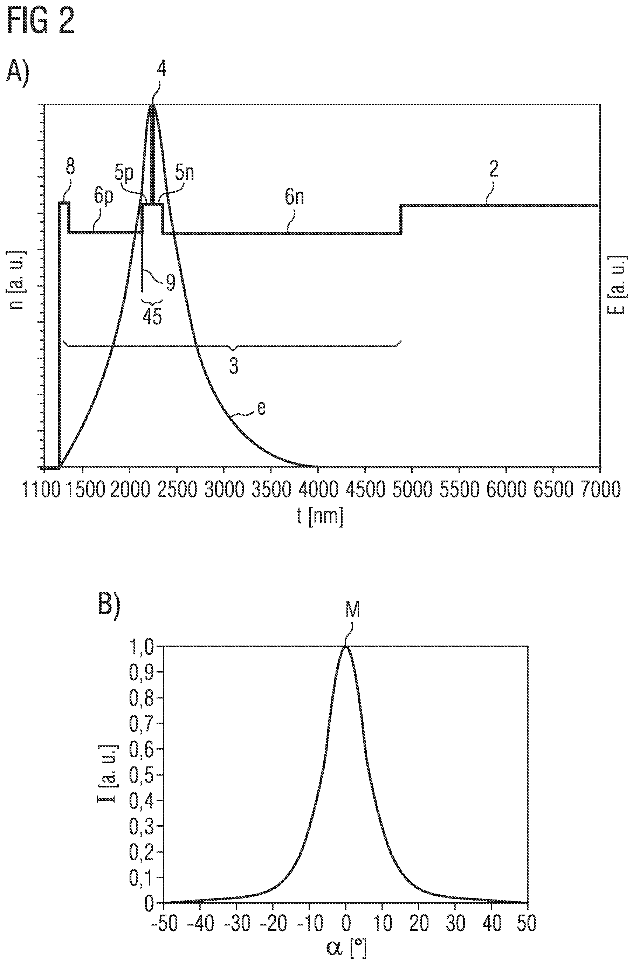

Bei der Laserdiode gemäß Figur 2 ist die Dicke der n-Mantelschicht 6n auf zirka 2,5 $\mu$m vergrößert. Ein Aluminiumgehalt der auf AlGaN basierenden n-Mantelschicht 6n liegt, wie auch gemäß Figur 1, bei zirka 5 % bis 10 %. Der effektive Brechungsindex der geführten Mode M ist dabei kleiner als der Brechungsindex des Trägers 2. Durch die vergrößerte Dicke der n-Mantelschicht 6n im Vergleich zu Figur 1 klingt das evaneszente Feld innerhalb der Mantelschicht 6n soweit ab, dass sich keine zusätzliche Mode in dem Träger 2 ausbilden kann.

Allerdings wachsen Schichten wie diese Mantelschicht 6n, die einen vergleichsweise hohen Aluminiumgehalt aufweist, auf GaN nur verspannt auf. Solche Verspannungen beeinträchtigen einerseits die Wachstumsqualität, andererseits können sich Risse in Schichten der Halbleiterschichtenfolge ausbilden, die zu einer Beschädigung des Bauteils führen können. Aufgrund der vergleichsweise großen erforderlichen Dicke erhöhen sich weiterhin die Wachstumszeiten und damit die Herstellungskosten. Somit beeinträchtigen vergleichsweise dicke Mantelschichten mit einem relativ hohen Aluminiumanteil die Qualität des Bauteils und führen zu erhöhten Herstellungskosten.

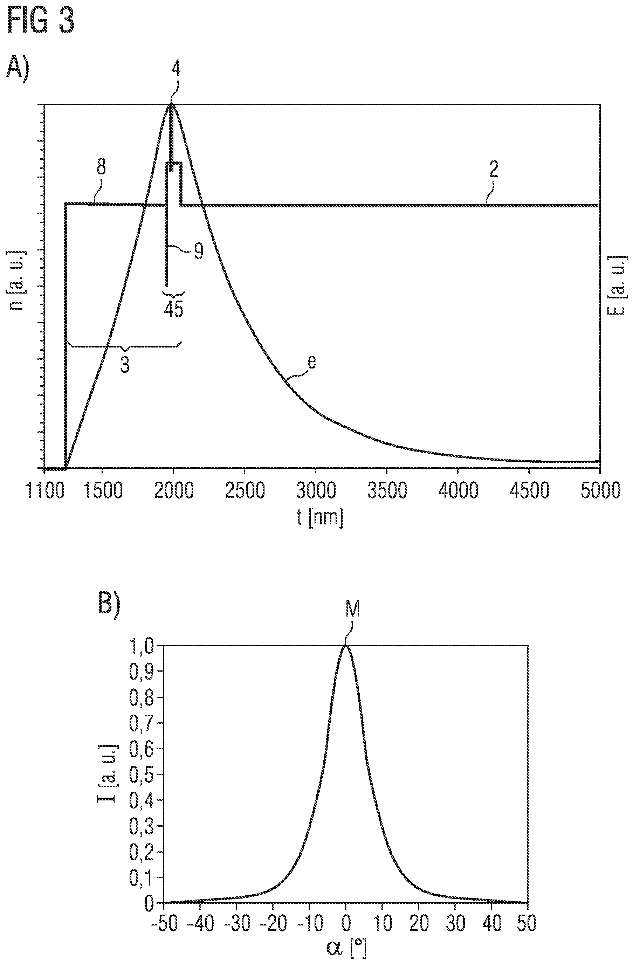

Bei der Laserdiode gemäß Figur 3 sind die Mantelschichten durch auf GaN basierende Schichten ohne signifikanten Aluminiumanteil ersetzt, die Laserdiode weist also keine Mantelschichten mit einem kleineren Brechungsindex als der des Trägers 2 auf. Der Wellenleiter 45 basiert auf InGaN. Aufgrund des höheren Brechungsindexes des InGaN-basierten Wellenleiters 45 kann sich keine parasitäre Mode in dem Träger 2 ausbilden. Allerdings werden relativ hohe Indiumgehalte in dem Wellenleiter 45 benötigt, was zu einer schlechteren Materialqualität führt. Bei epitaktisch gut realisierbaren Indiumgehalten ist andererseits ein Füllfaktor, also ein Intensitätsüberlapp der geführten Mode M mit der aktiven Zone 4, relativ gering, was zu einer vergleichsweise kleinen Verstärkung in der aktiven Zone 4 führt. Weiterhin wird eine vergleichsweise sehr dicke Schicht 8 nötig, um zu vermeiden, dass ein evaneszentes Feld zu einem in Figur 3 nicht gezeichneten p-Kontakt an einer dem Träger 2 abgewandten Seite der Halbleiterschichtenfolge 3 gelangt. Mit anderen Worten ist die Laserdiode gemäß Figur 3 ebenfalls teuer in der Herstellung und weist eine vergleichsweise geringe Effizienz auf.

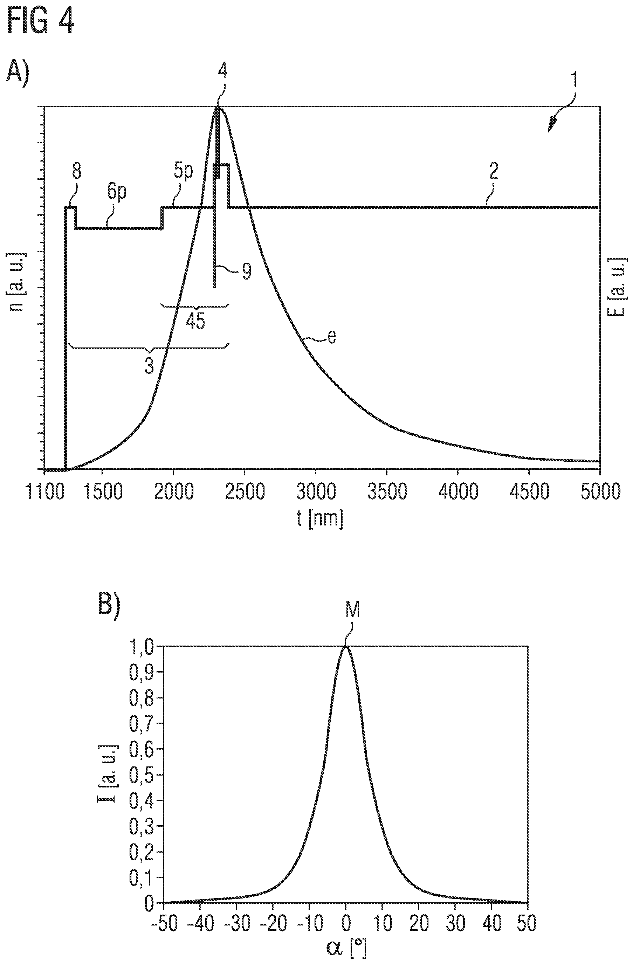

In Figur 4 ist ein Ausführungsbeispiel eines optoelektronischen Halbleiterchips 1 dargestellt. An einer dem Träger 2 abgewandten Seite des Wellenleiters 45 ist eine p-Mantelschicht 6p erzeugt. Durch die p-Mantelschicht 6p erfolgt eine verbesserte Abschirmung des evaneszenten Feldes gegenüber einem nicht gezeichneten p-Kontakt, im Vergleich zur Laserdiode gemäß Figur 3. Weiterhin kann ein höherer Füllfaktor erzielt werden, der im Ausführungsbeispiel gemäß Figur 4 zirka 2,4 % beträgt.

Als Materialien für die p-Mantelschicht 6p kann beispielsweise AlGaN oder AlInN oder AlInGaN eingesetzt werden. Insbesondere AlInGaN-haltige Schichten können mit guter Gitteranpassung auf GaN aufgewachsen werden. Anders als in Figur 4 gezeigt ist es möglich, dass die Mantelschicht 6p eine Übergitterstruktur aufweist.

Basiert die Mantelschicht 6p auf AlGaN, so liegt ein Aluminiumgehalt zum Beispiel zwischen einschließlich 0,01 % und 30 %, bevorzugt zwischen einschließlich 1 % und 12 %, besonders bevorzugt zwischen einschließlich 3 % und 8 %. Wird AlInN als Basismaterial für die Mantelschicht 6p verwendet, so beträgt der Aluminiumgehalt bevorzugt zwischen einschließlich 74 % und 90 %, besonders bevorzugt zwischen einschließlich 79 % und 85 %, insbesondere zirka 82 %. Im Falle von AlInGaN wird bevorzugt $Ga_x (Al_{82}In_{18})_{1-x}N$ verwendet, wobei der Aluminiumgehalt um bis zu 8 Prozentpunkte vom genannten Wert von 82 % abweichen kann und x bevorzugt zwischen einschließlich 0,01 und 0,3 liegt. Eine Dicke der p-Mantelschicht 6p liegt bevorzugt zwischen einschließlich 10 nm und 1500 nm, besonders bevorzugt zwischen einschließlich 100 nm und 1000 nm. Die genannten Materialien und Dicken können auch für die p-Mantelschichten 6p in allen anderen Ausführungsbeispielen herangezogen werden.

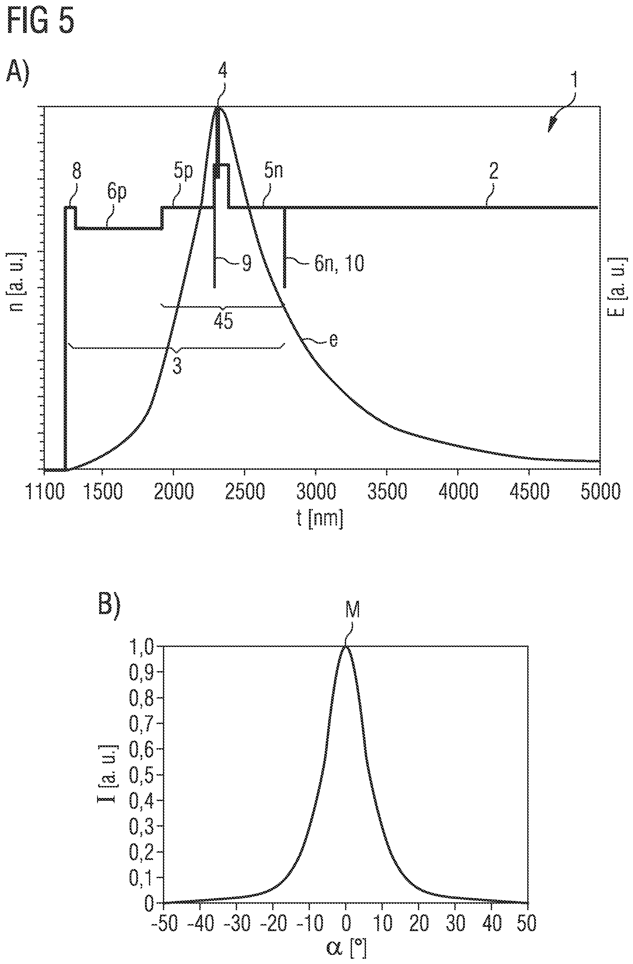

Beim Ausführungsbeispiel gemäß Figur 5 ist als n-Mantelschicht 6n eine Löcherbarrierenschicht 10, basierend auf AlGaN, ausgebildet. Durch die Löcherbarrierenschicht 10 steigt der Füllfaktor auf zirka 2,6 % an. Weiterhin ist eine Injektion von Löchern in die aktive Zone 4 verbessert, so dass eine Effizienz des Halbleiterlaserchips 1 ansteigt.

Die Löcherbarriereschicht 10, die die n-Mantelschicht 6n bildet, kann auf denselben Materialien basieren wie die in Verbindung mit Figur 4 genannte p-Mantelschicht 6p. Jedoch ist die n-Mantelschicht 6n bevorzugt n-dotiert. Eine Dicke der n-Mantelschicht 6n beziehungsweise der Löcherbarrierenschicht 10 liegt bevorzugt zwischen einschließlich 1 nm und 50 nm. Im Falle von AlGaN als Basismaterial liegt der Aluminiumgehalt bevorzugt zwischen einschließlich 1 % und 100 %, insbesondere zwischen einschließlich 3 % und 40 %, besonders bevorzugt zwischen einschließlich 3 % und 20 %. Die genannten Werte können auch in allen anderen Ausführungsbeispielen Anwendung finden.

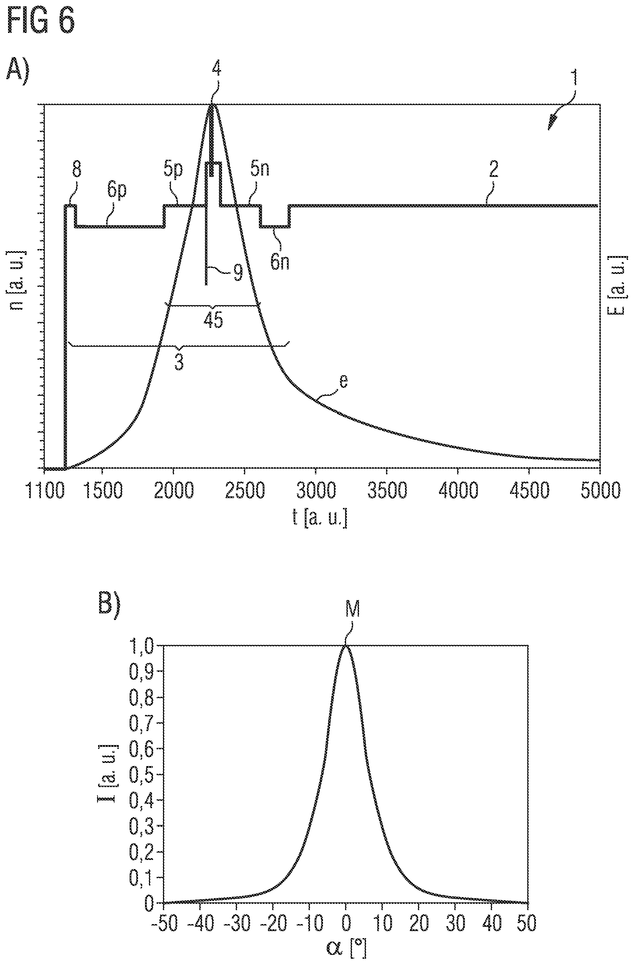

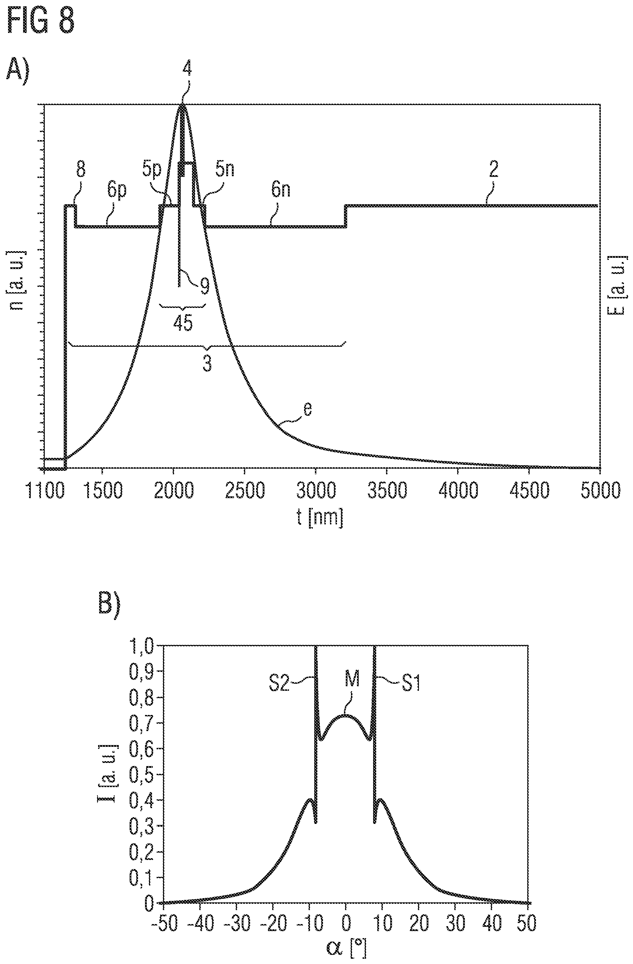

Beim Ausführungsbeispiel des Halbleiterchips 1 gemäß Figur 6 ist anstelle der Löcherbarrierenschicht 10 die Mantelschicht 6n durch eine AlGaN-Schicht mit demselben Aluminiumgehalt wie die p-Mantelschicht 6p gebildet, wobei die n-Mantelschicht 6n eine Dicke von zirka 200 nm aufweist. Der Füllfaktor beim Ausführungsbeispiel gemäß Figur 6 beträgt zirka 2,8 %. Je größer die Dicke der n-Mantelschicht 6n gemäß Figur 6 ist, desto kleiner wird der effektive Brechungsindex der geführten Mode M. Daher darf die n-Mantelschicht 6n nicht zu dick gewählt werden. Wird die Dicke der n-Mantelschicht 6n zu groß gewählt, wie bei der Laserdiode gemäß Figur 8, bei der die Dicke zirka 1000 nm beträgt, so treten parasitäre Moden S1, S2 auf, siehe Figur 8B.

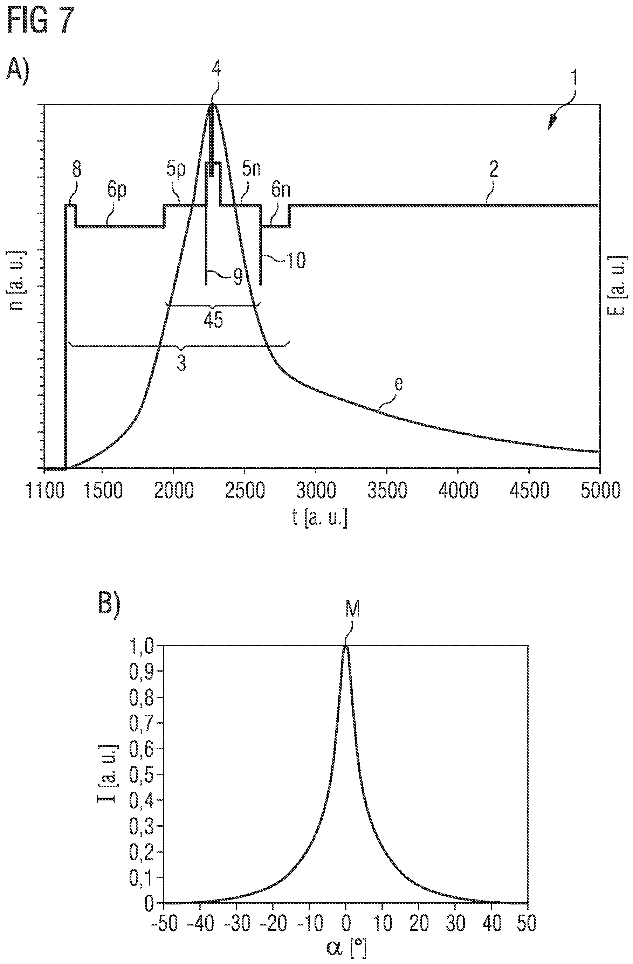

Beim Ausführungsbeispiel gemäß Figur 7 weist der Halbleiterchip 1 Mantelschichten 6n, 6p mit voneinander verschiedenen Brechungsindex und Aluminiumgehalt auf. Gemäß Figur 7 beträgt der Aluminiumgehalt der n-Mantelschicht 6n zirka 5 %, der Aluminiumgehalt der Löcherbarriere 10 beträgt zirka 20 %. Der Füllfaktor beträgt 7 zirka 3,7 % und ist somit vergleichsweise hoch.

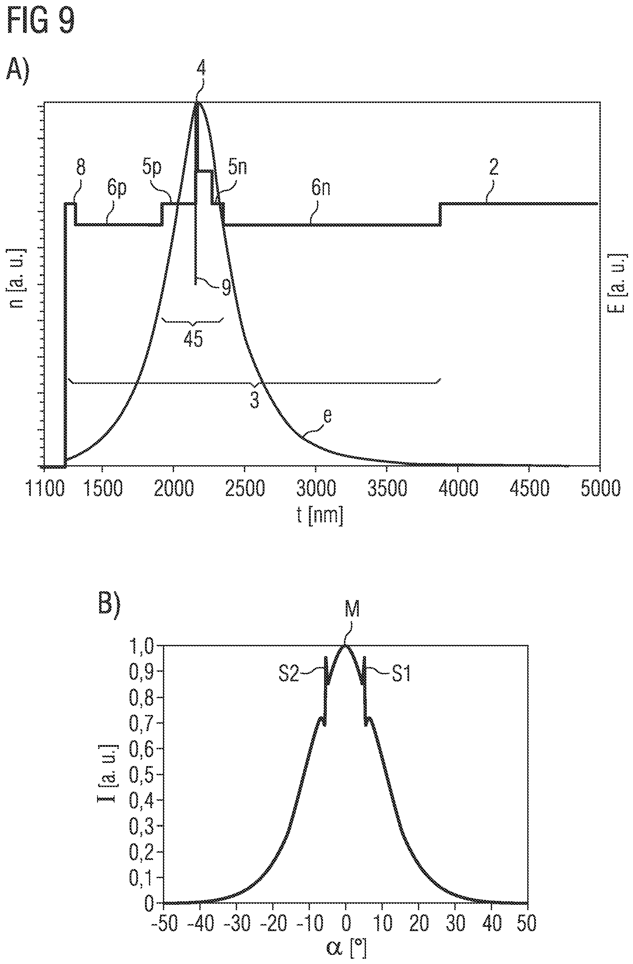

Bei der Laserdiode gemäß Figur 9 beträgt eine Dicke der n-Mantelschicht 6n zirka 1,5 $\mu$m und ein Aluminiumgehalt der auf AlGaN basierenden n-Mantelschicht 6n liegt bei zirka 5 %. Hierdurch wird das evaneszente Feld nicht hinreichend von dem Träger 2 abgeschirmt, wodurch sich parasitäre Moden S1, S2 bilden.

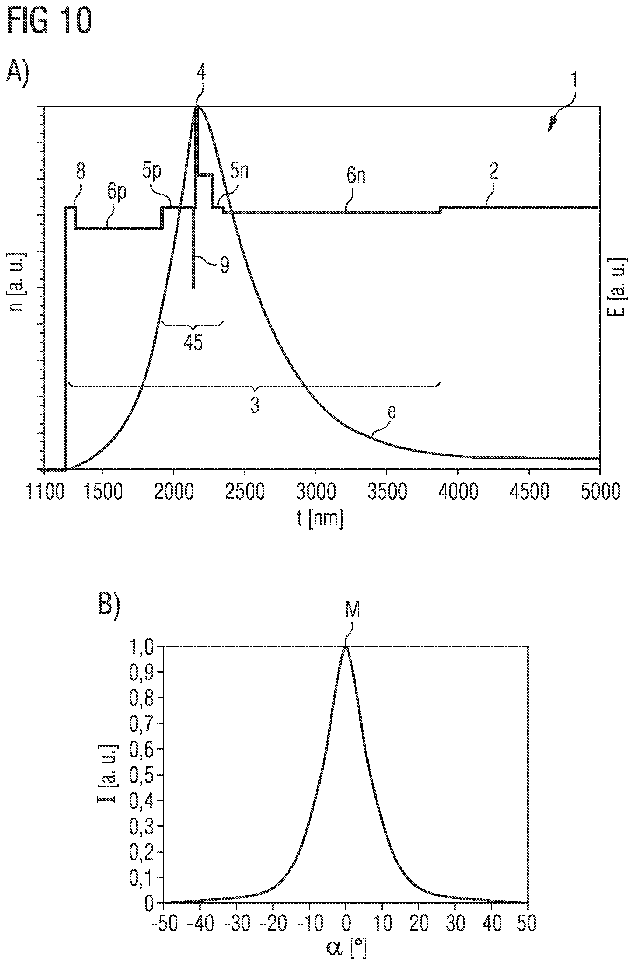

Wird, vergleiche das Ausführungsbeispiel gemäß Figur 10, jedoch der Aluminiumgehalt der Mantelschicht auf zirka 1 % abgesenkt, so tritt keine parasitäre Mode mehr auf, da der effektive Brechungsindex für die geführte Mode M größer ist als der Brechungsindex des Trägers 2. Mit anderen Worten ist es in diesem Ausführungsbeispiel wichtig, dass das Produkt aus der Dicke der n-Mantelschicht 6n und einem Brechungsindexunterschied zwischen der n-Mantelschicht 6n und dem angrenzenden Wellenleiter 45 nicht zu groß ist, wobei der Brechungsindexunterschied insbesondere durch den Aluminiumgehalt der Schichten bestimmt ist. Eine größere Dicke bedingt hiernach also einen geringeren Aluminiumgehalt und umgekehrt.

Je nach Aluminiumgehalt und Dicke der n-Mantelschicht 6n, die aufeinander abzustimmen sind, liegt deren Dicke insbesondere im Bereich zwischen 0,1 nm und 2000 nm, bevorzugt zwischen einschließlich 1 nm und 1000 nm, besonders bevorzugt zwischen einschließlich 5 nm und 500 nm. Im Falle von AlGaN als Basismaterial für die n-Mantelschicht 6n liegt der Aluminiumgehalt insbesondere zwischen einschließlich 0,01 % und 100 %, bevorzugt zwischen einschließlich 0,01 % und 20 %, besonders bevorzugt zwischen einschließlich 0,1 % und 10 %. Dies kann auch bei allen anderen Ausführungsbeispielen gelten. Ebenso wie für die p-Mantelschicht gemäß Figur 4 können auch bei dem vorliegenden Ausführungsbeispiel als Basismaterialien AlGaN, AlInN oder AlInGaN sowie Übergitter und/oder Kombinationen hieraus Verwendung finden.

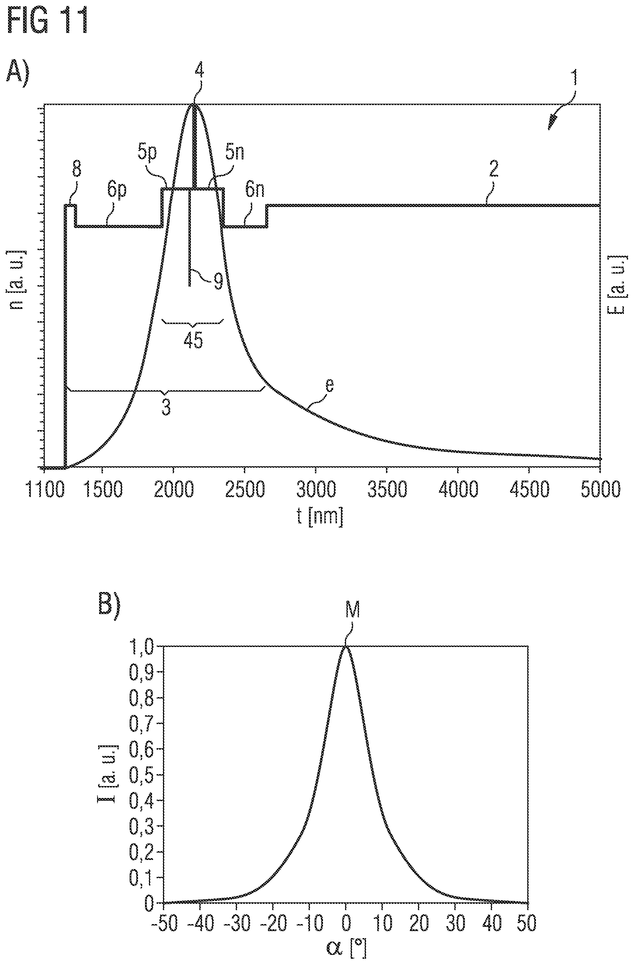

Gemäß Figur 11 basieren die Wellenleiterschichten 5n, 5p auf InGaN mit einem Indiumgehalt von zirka 2 %. Ein Füllfaktor des Halbleiterchips 1 bei diesem Ausführungsbeispiel beträgt zirka 2,8 %.

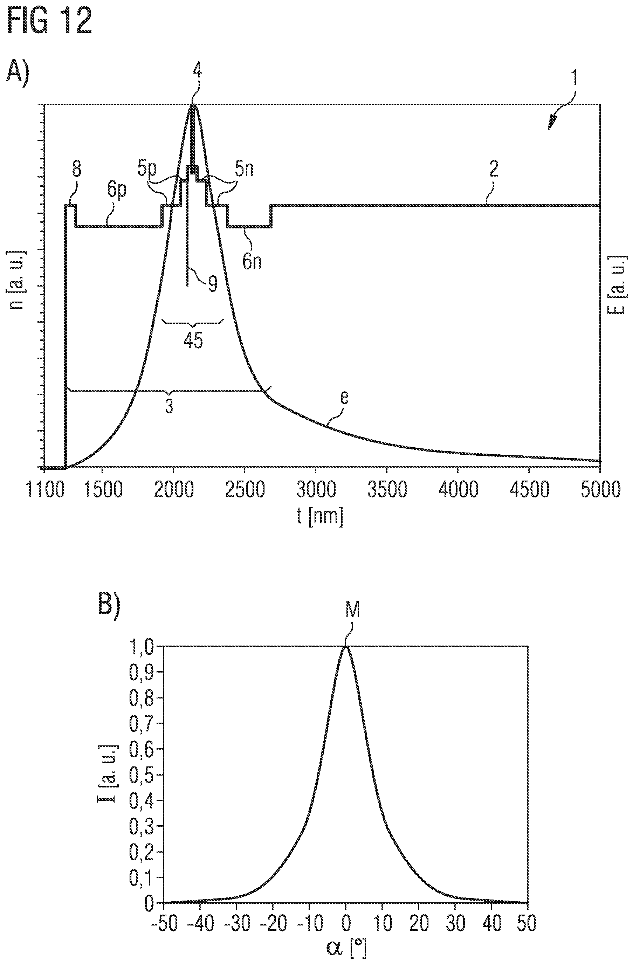

Beim Ausführungsbeispiel des Halbleiterchips 1 gemäß Figur 12 sind die Wellenleiterschichten 5n, 5p jeweils bezüglich ihres Brechungsindexverlaufs gestuft ausgebildet. Eine der aktiven Zone 4 näher gelegene Stufe der gestuften Struktur ist beispielsweise durch InGaN-Barrieren mit hohem Indiumgehalt, beispielsweise um zirka 5 %, gebildet. In eine Richtung weg von der aktiven Zone 4 ist jeweils eine zweite Stufe geformt, mit einem Indiumgehalt von zirka 3 %. Ein Füllfaktor beträgt zirka 3,2 %.

Wie auch in allen anderen Ausführungsbeispielen möglich, liegt der Indiumgehalt der Wellenleiterschichten 5n, 5p oder der Stufen der Wellenleiterschichten 5n, 5p jeweils bevorzugt zwischen 0 % und einschließlich 30 %, insbesondere zwischen einschließlich 0,1 % und 10 %, besonders bevorzugt zwischen einschließlich 1 % und 6 %. Es ist möglich, dass einer der Wellenleiter 5n, 5p auf GaN basiert, und die andere Wellenleiterschicht 5n, 5p auf InGaN. Dicken der Wellenleiterschichten 5n, 5p liegen zum Beispiel im Bereich zwischen einschließlich 0,1 nm und 500 nm, bevorzugt zwischen einschließlich 1 nm und 200 nm, besonders bevorzugt zwischen einschließlich 10 nm und 100 nm.

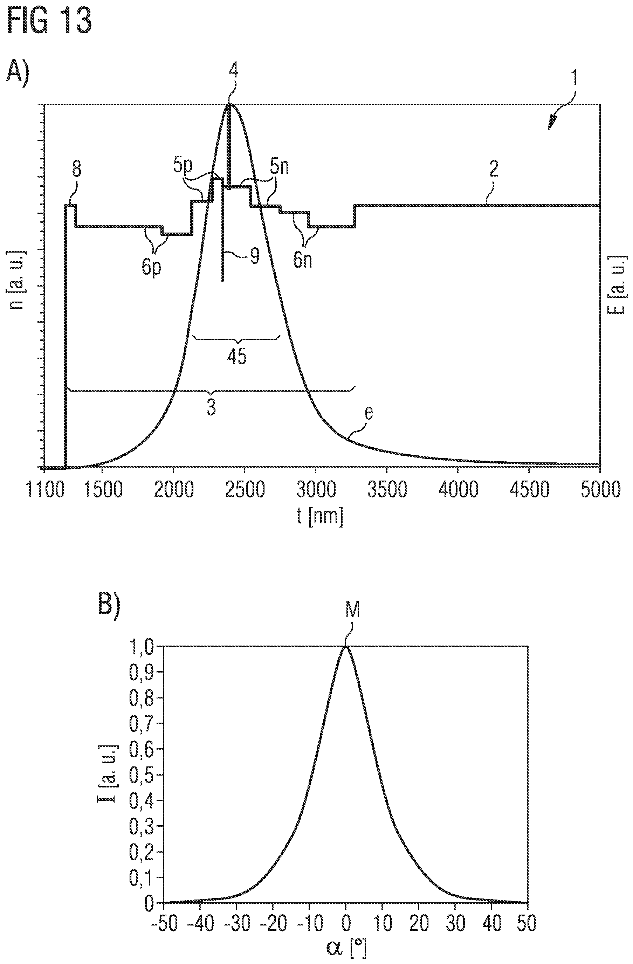

Im Ausführungsbeispiel gemäß Figur 13 sind sowohl die Wellenleiterschichten 5n, 5p als auch die Mantelschichten 6n, 6p gestuft ausgebildet. In Richtung hin zum Träger nimmt, ausgehend von der aktiven Zone 4, der Brechungsindex der Wellenleiterschicht 5n und der Mantelschicht 6n monoton ab. Eine Teilschicht der p-Mantelschicht 6p, die sich näher an der aktiven Zone 4 befindet, weist einen kleineren Brechungsindex auf als eine weitere Teilschicht der p-Mantelschicht 6p, die sich weiter von der aktiven Zone 4 entfernt befindet. In Richtung weg von dem Träger 2, ausgehend von der aktiven Zone 4, weist der Brechungsindex also keinen monotonen, sondern einen wellenartigen Verlauf auf.

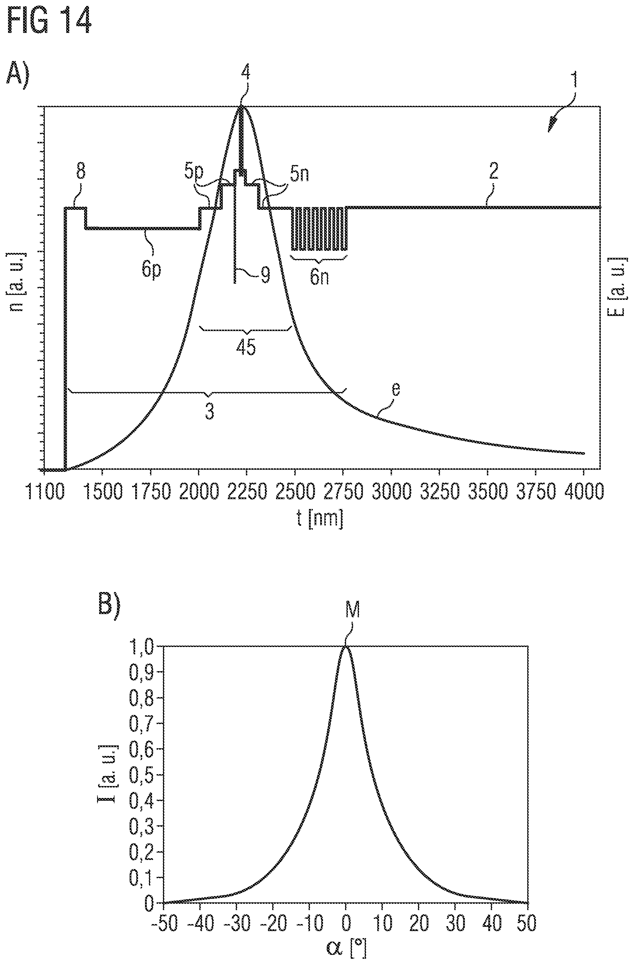

Beim Ausführungsbeispiel gemäß Figur 14 ist die n-Mantelschicht 6n durch eine Übergitterstruktur gebildet. Die Übergitterstruktur umfasst insbesondere zwischen einschließlich 2 und 300 Schichten mit abwechselnd hohem und niedrigem Brechungsindex. Die Schichten mit niedrigem Brechungsindex basieren zum Beispiel auf AlGaN. Eine Dicke der Schichten liegt beispielsweise zwischen einschließlich 1 nm und 70 nm.

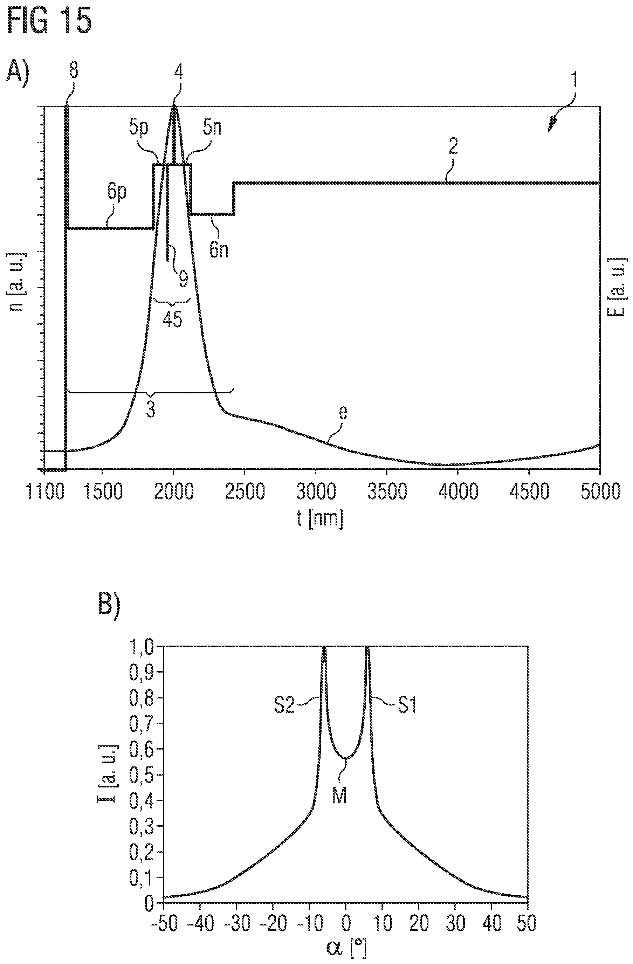

Bei der Laserdiode gemäß Figur 15 weist die n-Mantelschicht 6n eine Dicke von zirka 300 nm auf. Diese Dicke der n-Mantelschicht 6n ist derart gering, dass ein evaneszentes Feld in den Träger 2 reicht und dort zur Ausbildung parasitärer Moden S1, S2 führt, die eine hohe Intensität aufweisen.

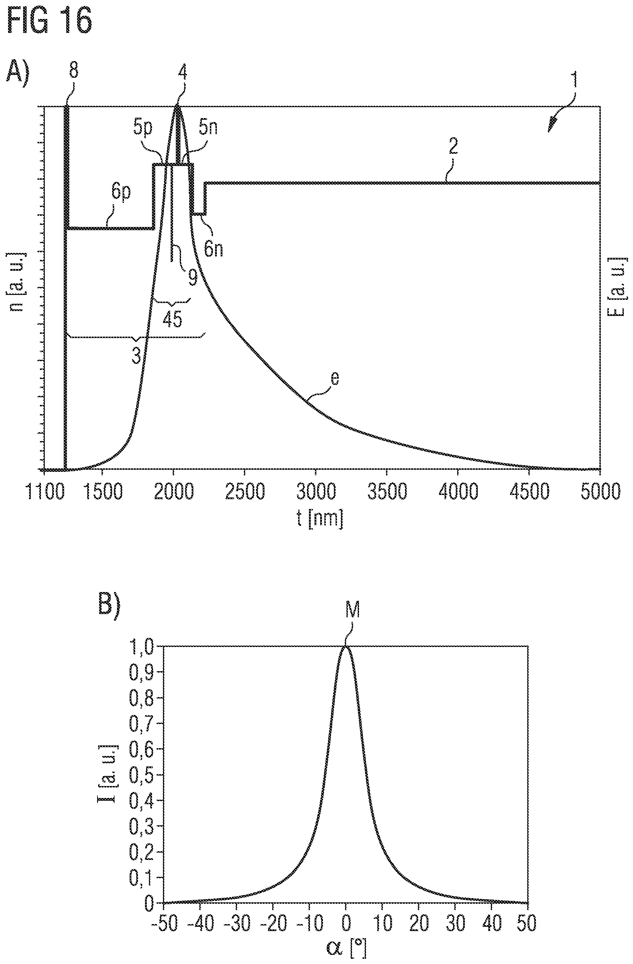

Demgegenüber ist beim Ausführungsbeispiel gemäß Figur 16 die Dicke der n-Mantelschicht 6n verringert, so dass der effektive Brechungsindex der geführten Mode M größer ist als der Brechungsindex des Trägers 2, wodurch das Entstehen von parasitären Moden unterbunden ist. Die parasitären Moden entfallen also nicht durch eine Vergrößerung der Dicke der Mantelschicht, sondern durch eine Verringerung der Dicke.

Der Halbleiterchip 1 gemäß dem Ausführungsbeispiel nach Figur 16 ist bevorzugt ein im Ultravioletten emittierender Halbleiterlaserchip. Der Träger 2 ist insbesondere ein Aufwachssubstrat, basierend auf AlN, AlGaN, AlInGaN oder AlInN. Je nach Aluminiumgehalt weisen die genannten Materialien für den Träger 2 einen geringeren Brechungsindex auf als GaN. Der Wellenleiter 45 kann daher auf GaN basieren und/oder GaN-Barriereschichten umfassen. Für eine in der aktiven Zone 4 zu erzeugende Wellenlänge von kleiner oder gleich 365 nm können auch GaN-basierte Quantenfilme mit AlGaN-basierten Wellenleiterschichten 5n, 5p verwendet werden. Basiert der Träger 2 auf InGaN, AlInN oder auf AlInGaN, wobei diese Materialien einen höheren Brechungsindex aufweisen als GaN, so weist der Wellenleiter 45 besonders bevorzugt einen noch höheren Brechungsindex auf als der Träger 2.

beim Ausführungsbeispiel gemäß Figur 17A ist, um eine Injektion von Ladungsträger in die Halbleiterschichtenfolge 3 zu erleichtern und um einen Spannungsabfall an der Halbleiterschichtenfolge 3 zu verringern, die Halbleiterschichtenfolge 3, beginnend mit der auf AlGaNbasierenden n-Mantelschicht 6n, direkt auf den Träger 2 aufgewachsen. Der Träger 2 ist dabei ein hoch dotiertes Substrat, bevorzugt ein GaN-Substrat. Hoch dotiert bedeutet, dass eine Dotierstoffkonzentration, beispielsweise von Silizium oder Sauerstoff, zwischen einschließlich $1 \times 10^{18}$ pro $cm^3$ und $1 \times 10^{20}$ pro $cm^3$ beträgt. Die Mantelschichten 6n, 6p sowie die Wellenleiterschichten 5n, 5p sind weiterhin beispielsweise ausgeformt, wie auch im Ausführungsbeispiel gemäß Figur 11 oder Figur 12.

Gemäß Figur 17B ist auf dem bevorzugt auf GaN basierenden Träger 2 zusätzlich eine hoch dotierte Schicht 7, basierend bevorzugt auf GaN, aufgebracht. Eine Dotierstoffkonzentration der hoch dotierten Schicht 7 liegt im Bereich zwischen einschließlich $1 \times 10^{18}$ pro $cm^3$ und $1 \times 10^{20}$ pro $cm^3$ oder zwischen einschließlich $5 \times 10^{18}$ pro $cm^3$ und $5 \times 10^{19}$ pro $cm^3$. Die Dotierung erfolgt zum Beispiel mit Silizium oder mit Sauerstoff. Eine Dicke der hoch dotierten Schicht 7 liegt zum Beispiel zwischen einschließlich 1 nm und 10 $\mu$m, bevorzugt zwischen einschließlich 100 nm und 4 $\mu$m, besonders bevorzugt zwischen einschließlich 0,5 $\mu$m und 2 $\mu$m.

Um zusätzliche optische Absorptionsverluste zu vermeiden, ist beim Ausführungsbeispiel gemäß Figur 17C die hoch dotierte Schicht 7 nicht direkt an die n-Mantelschicht 6n angrenzend geformt. Zwischen der n-Mantelschicht 6n und der hoch dotierten Schicht 7 befindet sich eine Zwischenschicht 67, die beispielsweise eine Dotierstoffkonzentration im Bereich zwischen einschließlich $5 \times 10^{17}$ pro $cm^3$ und $5 \times 10^{18}$ pro $cm^3$ aufweist. Eine Dicke der Zwischenschicht 67 liegt bevorzugt zwischen einschließlich 500 nm und 2 $\mu$m.

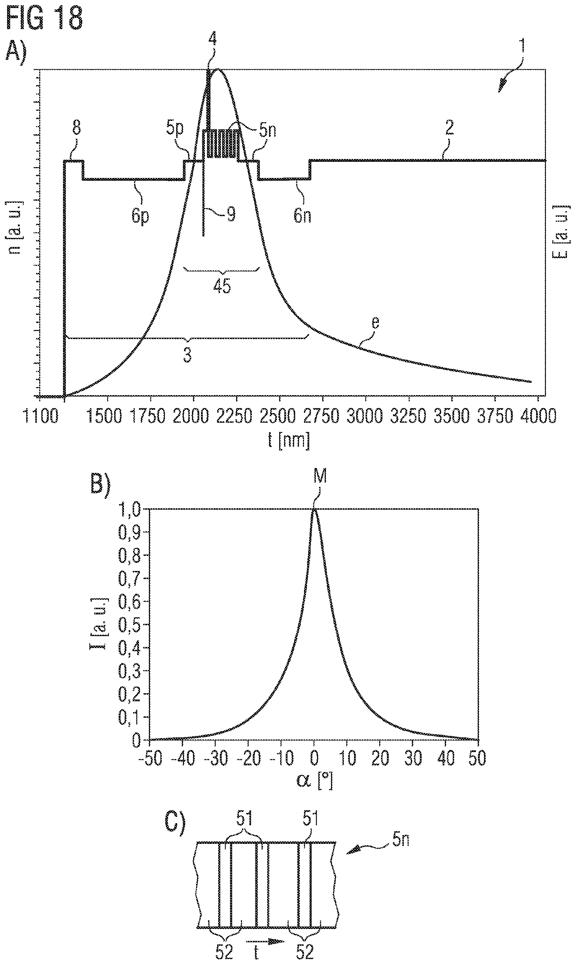

Beim Ausführungsbeispiel gemäß Figur 18 umfasst die n-Wellenleiterschicht 5n ein Übergitter. Das Übergitter ist durch erste Schichten 51 und durch zweite Schichten 52 gebildet, die abwechselnd aufeinander folgen. Die ersten Schichten 51 basieren zum Beispiel auf InGaN mit einem Indiumgehalt zwischen einschließlich 0 % und 10 %, bevorzugt zwischen einschließlich 0 % und 5 %. Eine Dicke der ersten Schichten 51 liegt zwischen einschließlich 0,1 nm und 50 nm, bevorzugt zwischen einschließlich 1 nm und 5 nm. Die zweiten Schichten 52 basieren ebenfalls auf InGaN mit einem Indiumgehalt zwischen einschließlich 1 % und 25 %, bevorzugt zwischen einschließlich 3 % und 10 %. Eine Dicke der zweiten Schichten 52 beträgt insbesondere zwischen einschließlich 0,1 nm und 50 nm, bevorzugt zwischen einschließlich 1 nm und 20 nm. Eine Dicke der zweiten Schichten 52 ist hierbei jeweils größer als eine Dicke der ersten Schichten 51 und ein Indiumgehalt der ersten Schichten 51 ist kleiner als ein Indiumgehalt der zweiten Schichten 52, siehe auch die schematische Schnittdarstellung in Figur 18C.

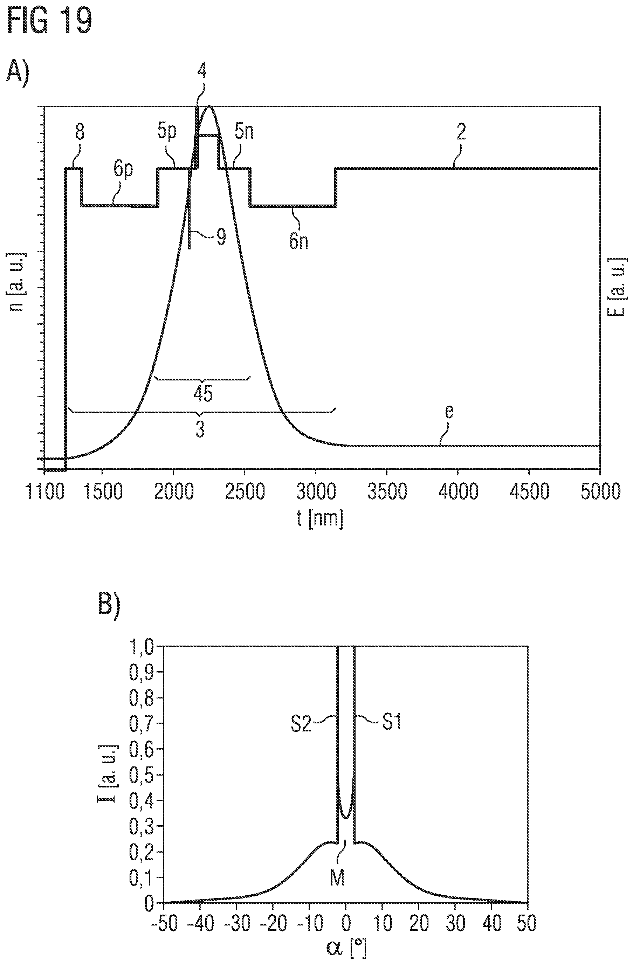

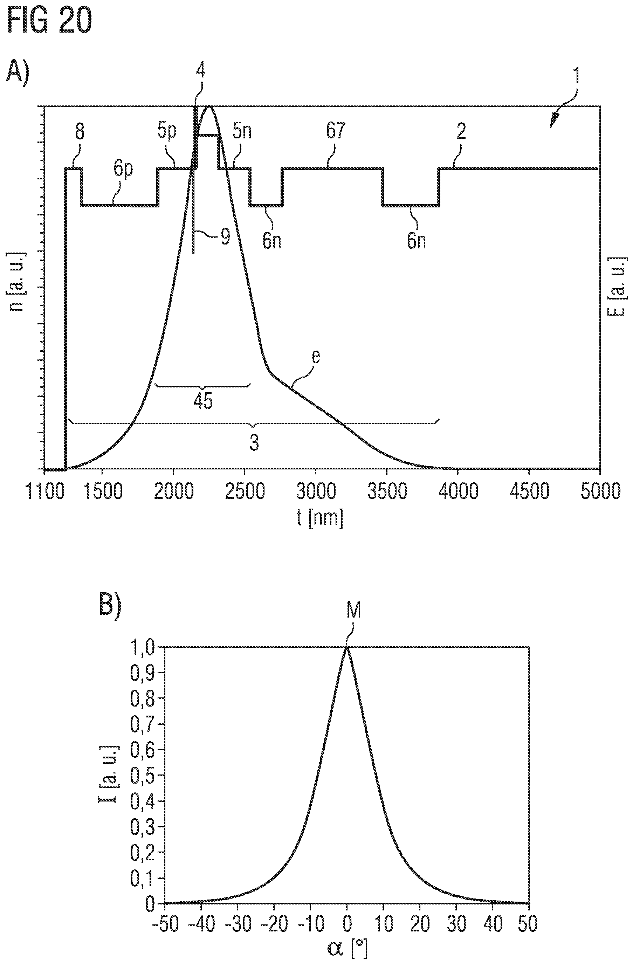

Bei der herkömmlichen Laserdiode gemäß Figur 19 bildet sich eine Trägermode S1, S2 aus. Im Vergleich dazu ist die Trägermode S1, S2 im Ausführungsbeispiel des Halbleiterchips 1 gemäß Figur 20 nicht vorhanden. Dies ist dadurch erreicht, dass die n-Mantelschicht 6n in mehrere Teilschichten aufgeteilt ist. Die Teilschichten sind durch die Zwischenschicht 67 voneinander separiert, die insbesondere auf GaN basiert und einen Brechungsindex aufweist, der näherungsweise dem des Trägers 2 entspricht.

Beispielsweise weist die Teilschicht, die weiter von der aktiven Zone 4 entfernt ist, eine größere Dicke auf als die Teilschicht, die sich näher an der aktiven Zone 4 befindet. Die Dicken der Teilschichten liegen insbesondere zwischen einschließlich 100 nm und 600 nm. Die Zwischenschicht 67 ist bevorzugt dicker ausgeführt als eine oder als alle Teilschichten der n-Mantelschicht 6n. Eine Dicke der Zwischenschicht 67 beträgt insbesondere zwischen einschließlich 200 nm und 1000 nm. Eine derart in mindestens zwei Teilschichten aufgeteilte n-Mantelschicht 6n ist auch in den anderen Ausführungsbeispielen des Halbleiterchips 1 einsetzbar.

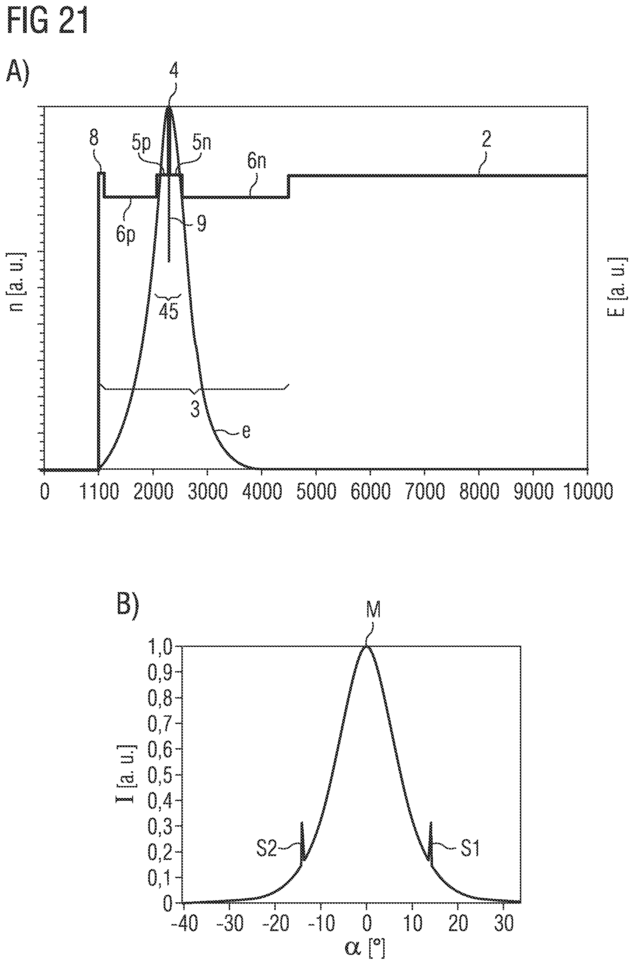

Die Laserdiode gemäß Figur 21 weist zwei im Vergleich zur im Wellenleiter 45 geführten Mode M kleine Substratmoden S1, S2 auf, da der effektiver Brechungsindex für die geführte Mode M kleiner ist als der Brechungsindex des Trägers 2. Durch eine Veränderung zum Beispiel der n-Mantelschicht 6n, wie insbesondere in einem der oben angeführten Ausführungsbeispiele angegeben, und den damit verbundenen Anstieg des effektiven Brechungsindexes für die geführte Mode M sind die Substratmoden S1, S2 unterdrückbar. Ein Schichtaufbau des Laserdiode gemäß Figur 21 ist daher in analoger Weise für die angeführten Ausführungsbeispiele heranziehbar.

Der Schichtaufbau der Laserdiode gemäß Figur 21 ist wie folgt, ausgehend vom Träger 2 und in eine Richtung hin zu der Kontaktschicht 8:

- Der Träger 2 besteht aus insbesondere dotiertem GaN, weist eine Dicke von zirka 100 $\mu$m und einen Brechungsindex von 2,489 auf. Die Angaben der Brechungsindices beziehen sich, wie auch bei den Ausführungsbeispielen, jeweils auf eine Wellenlänge maximaler Intensität, zu deren Emission die Laserdiode beziehungsweise der Halbleiterchip 1 eingerichtet ist.
- Die n-Mantelschicht 6n weist eine Dicke von zirka 2000 nm auf und hat einen Brechungsindex von 2,447. Ein Material der n-Mantelschicht 6n ist AlGaN mit einem Al-Anteil von 5 %.
- Die n-Wellenleiterschicht 5n ist aus GaN gebildet, hat einen Brechungsindex von 2,469 und eine Dicke von zirka 200 nm.
- Die aktive Zone 4 weist drei Quantenfilme auf, die jeweils eine Dicke von zirka 3 nm haben, mit InGaN mit einem In-Anteil von zirka 17 % gebildet sind und einen Brechungsindex von 2,527 haben. Zwischen zwei benachbarten Quantenfilmen befindet sich jeweils eine Barriereschicht aus GaN mit Dicken von zirka 8 nm und zirka 10 nm und einem Brechungsindex von 2,469.
- Zwischen der aktiven Zone 4 und der Elektronenbarriereschicht 9 befindet sich eine Zwischenschicht mit GaN, die eine Dicke von zirka 10 nm und einen Brechungsindex von 2,469 aufweist. Die Elektronenbarriereschicht 9 hat eine Dicke von zirka 10 nm, einen Brechungsindex von 2,385 und basiert auf AlGaN mit einem Al-Anteil von 20 %.
- Die p-Wellenleiterschicht 5p weist eine Dicke von zirka 200 nm, einen Brechungsindex von 2,469 auf und basiert auf GaN.
- Die p-Mantelschicht 6p, basierend auf AlGaN mit einem Al-Anteil von 5 %, hat eine Dicke von zirka 1000 nm und einen Brechungsindex von 2,447.
- Die Kontaktschicht 8 basiert auf GaN, hat eine Dicke von zirka 50 nm und einen Brechungsindex von 2,469. Ein effektiver Brechungsindex für die geführte Mode M beträgt bei diesem Schichtaufbau 2,457.

Gemäß Figur 21 ist der Wellenleiter 45 eindimensional gestaltet, bei der Laserdiode gemäß Figur 22 ist der Wellenleiter zweidimensional gestaltet. Der Schichtaufbau entspricht dem aus Figur 21. Die Kontaktschicht 8 sowie die p-Mantelschicht 6p sind stellenweise über ein Ätzen entfernt, so dass ein Streifen 13, englisch ridge, mit einer Breite von zirka 2 $\mu$m ausgebildet ist, wobei der Streifen 13 von einem dem Träger 2 abgewandten Metallkontakt 11 bedeckt ist. Die Ätzung erfolgt also bis in eine Tiefe der Halbleiterschichtenfolge 3 von zirka 1050 nm. Die geätzten Bereiche sind in lateraler Richtung neben dem Streifen 13 mit einem Material 12 mit einem niedrigeren Brechungsindex als die p-Mantelschicht 6p, zum Beispiel mit Siliziumdioxid mit einem Brechungsindex von ungefähr 1,5 und einer Dicke von zirka 1000 nm, aufgefüllt. Hierdurch sinkt der effektive Brechungsindex für die geführte Mode M auf 2,455 ab, im Vergleich zu einem Wert von 2,457 gemäß Figur 21. Eine Halbwertbreite der Mode M, vergleiche Figuren 21B und 22B, reduziert sich um etwa einen Faktor 2 auf ungefähr 8,8°.

Ein derartiger, zweidimensionaler Wellenleiter 45, wie in Figur 22A dargestellt, ist insbesondere auch für alle Ausführungsbeispiele des Halbleiterchips 1 heranziehbar.

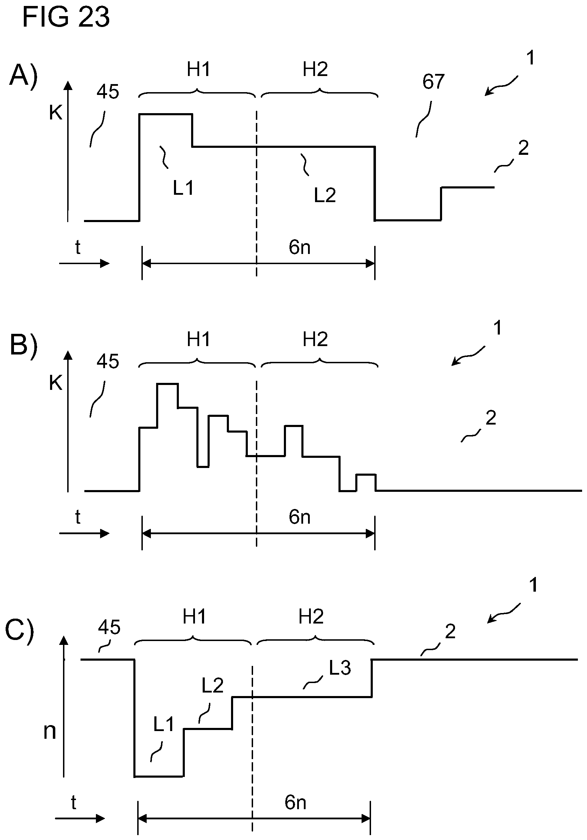

In Figur 23 sind Ausschnitte aus der Halbleiterschichtenfolge 3 von weiteren Ausführungsbeispielen des Halbleiterchips 1 anhand eines Verlaufs des Aluminiumgehalts K oder des Brechungsindexes n entlang der Tiefe t illustriert. Die Mantelschicht 6n ist jeweils in zwei gleich dicke, fiktive Hälften H1, H2 geteilt, wobei die erste Hälfte H1 näher an dem Wellenleiter 45 liegt als die zweite Hälfte H2. Ein mittlerer Aluminiumgehalt der ersten Hälfte H1 übersteigt einen mittleren Aluminiumgehalt der zweiten Hälfte H2.

Gemäß Figur 23A weist die n-Mantelschicht 6n genau zwei Stufen L1, L2 im Aluminiumgehalt auf. Innerhalb der Stufen L1, L2 ist der Aluminiumgehalt näherungsweise konstant. In Figur 23B ist eine n-Mantelschicht 6n dargestellt, die insgesamt elf Stufen aufweist. Die n-Mantelschicht 6n weist Teilschichten auf, die beiderseits von anderen Teilschichten mit jeweils höherem Aluminiumgehalt benachbart sind. In Figur 23C ist der Verlauf des Brechungsindexes entlang der Tiefe t gezeigt. In der ersten Hälfte H1 ist der mittlere Brechungsindex kleiner als in der zweiten Hälfte H2. Die n-Mantelschicht 6n umfasst drei Stufen L1, L2, L3.

Anders als in Figur 23 dargestellt, kann alternativ oder zusätzlich auch die p-Mantelschicht entsprechend ausgebildet sein.

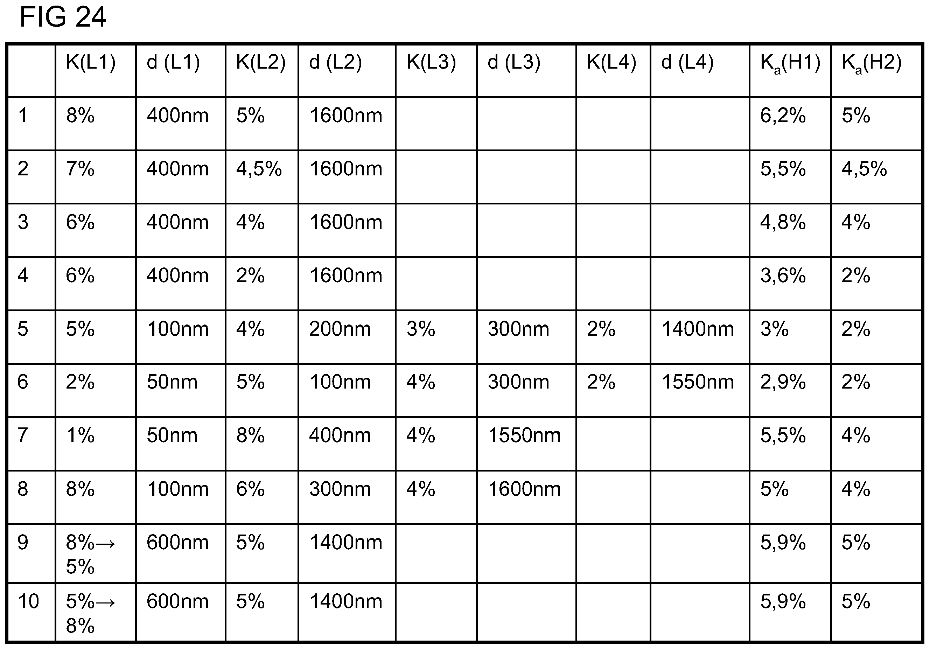

In Figur 24 sind Varianten von Ausführungsbeispielen des Halbleiterchips 1 anhand einer Tabelle und hinsichtlich der Mantelschichten 6n, 6p beschrieben. Für alle Varianten gilt, dass der mittlere Aluminiumgehalt Ka(H1) der erste Hälfte H1 größer ist als der mittlere Aluminiumgehalt Ka(H2) der zweiten Hälfte H2. Die Varianten 1 bis 8 weisen einen gestuften Verlauf des Aluminiumgehalts K auf, wobei jeweils der mittlere Aluminiumgehalt K(L1, L2, L3, L4) der Stufen L1, L2, L3, L4 sowie deren Dicken d(Li, L2, L3, L4) angegeben sind. Gemäß der Varianten 9 und 10 verläuft der Aluminiumgehalt K zuerst rampenförmig und dann in Form der Stufe L2. In Variante 9 nimmt der Aluminiumgehalt K in der Rampe, vom Wellenleiter 45 ausgehend, linear ab, gemäß Variante 10 linear zu.

Die in der Tabelle aufgeführten Werte können in Ausführungsbeispielen des Halbleiterchips 1 jeweils mit einer Toleranz von höchsten 25 % oder von höchstens 10 % realisiert sein, solange der mittlere Aluminiumgehalt Ka(H1) der ersten Hälfte H1 größer ist als der der zweiten Hälfte H2. Beispielsweise bedeutet eine Toleranz von höchsten 25 % bei einer in der Tabelle angegebenen Dicke von 400 nm, dass ein Dickenbereich von 400 nm ± 25 %, also von einschließlich 300 nm bis 500 nm, beschrieben ist.

## Patentansprüche

1. Optoelektronischer Halbleiterchip (1),
umfassend einen Träger (2) und eine auf dem Träger angebrachte, auf einem Nitrid-Verbindungshalbleitermaterial basierende Halbleiterschichtenfolge (3) mit

   - wenigstens einer aktiven Zone (4), die zur Erzeugung einer elektromagnetischen Strahlung vorgesehen ist,
   - wenigstens einer Wellenleiterschicht (5), die an die aktive Zone (4) grenzt, wobei ein Wellenleiter (45) gebildet wird, und
   - einer an die Wellenleiterschicht (5) grenzenden p-Mantelschicht (6p) an einer p-dotierten Seite und einer n-Mantelschicht (6n) an einer n-dotierten Seite der aktiven Zone (4),

   wobei

   - zumindest die n-Mantelschichten (6n) in wenigstens zwei Teilschichten mit voneinander verschiedenem mittleren Aluminiumgehalt aufgeteilt ist,
   - eine erste Hälfte (H1) der n-Mantelschicht (6n) einen höheren mittleren Aluminiumgehalt aufweist als eine zweite Hälfte (H2) der n-Mantelschicht (6n), wobei die Hälften (H1, H2) gleich dick sind, die Hälften (H1, H2) eine lediglich fiktive Unterteilung der n-Mantelschicht (6n) darstellen und die erste Hälfte (H1) sich näher an dem Wellenleiter (45) befindet,
   - der mittlere Aluminiumgehalt der ersten Hälfte (H1) den mittleren Aluminiumgehalt der zweiten Hälfte (H2) um mindestens 0,1 Prozentpunkte übersteigt,

   und

   - der mittlere Brechungsindex der n-Mantelschicht (6n) kleiner ist als der Brechungsindex des Trägers (2)
   **dadurch gekennzeichnet, dass**
   - der effektive Brechungsindex der in dem Wellenleiter (45) geführten Mode zwischen einem mittleren Brechungsindex der n-Mantelschicht (6n) und dem mittleren Brechungsindex des Wellenleiters (45) liegt,
   - ein effektiver Brechungsindex einer im Wellenleiter (45) geführten Mode größer ist als ein Brechungsindex des Trägers (2), und
   - ein evaneszentes Feld der an der p-Mantelschicht (6p) oder an der n-Mantelschicht (6n) totalreflektierten und in der aktiven Zone (4) erzeugten Strahlung bis in den Träger (2) reicht und eine Amplitude des evaneszenten Feldes in dem Träger (2), bezogen auf eine Ausgangsamplitude an einer totalreflektierenden Grenzfläche, stellenweise mindestens 2,5 % beträgt.

2. Optoelektronischer Halbleiterchip (1) nach dem vorhergehenden Anspruch,
bei dem eine Dicke der n-Mantelschicht (6n) höchstens 500 nm beträgt,
wobei ein mittlerer Aluminiumgehalt der n-Mantelschicht (6n) zwischen einschließlich 1 % und 12 % liegt,
wobei der Aluminiumgehalt in der n-Mantelschicht (6n), in eine Richtung weg von der aktiven Zone (4), abnimmt, und
wobei die n-Mantelschicht (6n) zwischen einschließlich 2 und 10 der Teilschichten aufweist, und
wobei die Teilschichten in eine Richtung weg von der aktiven Zone (4) eine monoton ansteigende Dicke aufweisen.

3. Optoelektronischer Halbleiterchip (1) nach einem der vorhergehenden Ansprüche,
bei dem der effektive Brechungsindex der in dem Wellenleiter (45) geführten Mode höchstens ein 1,05-faches des Brechungsindexes des Trägers (2) beträgt.

4. Optoelektronischer Halbleiterchip (1) nach einem der vorhergehenden Ansprüche,
bei dem sich in der n-Mantelschicht (6n) oder zwischen der n-Mantelschicht (6n) und dem Wellenleiter (45) eine Löcherbarriereschicht (10) befindet,
wobei eine Dicke der Löcherbarrierenschicht (10) zwischen einschließlich 1 nm und 50 nm liegt, und wobei die Löcherbarrierenschicht (10) AlGaN als Basismaterial aufweist mit einem Aluminiumgehalt zwischen einschließlich 3 % und 40 %.

5. Optoelektronischer Halbleiterchip (1) nach einem der vorhergehenden Ansprüche,
bei dem der Träger (2) ein Aufwachssubstrat ist, auf dem die Halbleiterschichtenfolge (3) epitaktisch aufgewachsen ist,
wobei die Wellenleiterschichten (5n, 5p) als auch die Mantelschichten (6n, 6p) hinsichtlich ihres Brechungsindexverlaufs gestuft ausgebildet sind, und wobei eine Teilschicht der p-Mantelschicht (6p), die sich näher an der aktiven Zone (4) befindet, einen kleineren Brechungsindex aufweist als eine weitere Teilschicht der p-Mantelschicht (6p), die sich weiter von der aktiven Zone (4) entfernt befindet.

6. Optoelektronischer Halbleiterchip (1) nach einem der vorhergehenden Ansprüche,
bei dem die Dicke (Tp) der p-Mantelschicht zwischen einschließlich 10 nm und 1500 nm beträgt.

7. Optoelektronischer Halbleiterchip (1) nach einem der vorhergehenden Ansprüche,
bei dem die p-Mantelschicht (6p) auf einem der folgenden Materialien basiert:

$Al_xGa_{1-x}N$ mit $0{,}0001 \leq x \leq 0{,}30$,
$Al_xIn_{1-x}N$ mit $0{,}0001 \leq x \leq 0{,}90$, oder
$(Al_{1-y}In_y)_xGa_{1-x}N$ mit $0{,}0001 \leq x \leq 0{,}90$ und $0{,}0001 \leq x \leq 0{,}3$.

8. Optoelektronischer Halbleiterchip (1) nach einem der vorhergehenden Ansprüche,
bei dem die n-Mantelschicht (6n) auf einem der folgenden Materialien basiert:

$Al_xGa_{1-x}N$ mit $0{,}0001 \leq x \leq 0{,}30$,
$Al_xIn_{1-x}N$ mit $0{,}0001 \leq x \leq 0{,}90$, oder
$(Al_{1-y}In_y)_xGa_{1-x}N$ mit $0{,}0001 \leq x \leq 0{,}90$ und $0{,}0001 \leq x \leq 0{,}3$ und/oder bei dem die n-Mantelschicht (6n) als Löcherbarriere eingerichtet ist.

9. Optoelektronischer Halbleiterchip (1) nach einem der vorhergehenden Ansprüche,
bei dem die aktive Zone (3) zwischen einschließlich 1 und 10 Quantenfilme aufweist,
wobei zu einer Verbesserung der Wellenführung in dem Wellenleiter (45) zwischen wenigstens zwei benachbarten Quantenfilmen eine auf $In_xGa_{1-x}N$ basierende Barriereschicht mit $0{,}0001 \leq x \leq 0{,}20$ und mit einer Dicke zwischen einschließlich 0,1 nm und 30 nm geformt ist.

10. Optoelektronischer Halbleiterchip (1) nach einem der vorhergehenden Ansprüche,
bei dem die Wellenleiterschicht (5) ein Übergitter mit Schichten (51, 52) mit abwechselnd hohem und niedrigem Brechungsindex und jeweils Dicken zwischen einschließlich 0,1 nm und 70 nm aufweist.

11. Optoelektronischer Halbleiterchip (1) nach dem vorhergehenden Anspruch,
bei dem das Übergitter abwechselnd erste Schichten (51), basierend auf $In_{x1}Ga_{1-x1}N$ mit $0{,}0001 \leq x \leq 0{,}10$, und zweite Schichten (52), basierend auf $In_{x2}Ga_{1-x2}N$ mit $0{,}0001 \leq x \leq 0{,}25$, aufweist.

12. Optoelektronischer Halbleiterchip (1) nach einem der vorhergehenden Ansprüche,
bei dem die p-Mantelschicht (6p) ein Übergitter mit Schichten (51, 52) mit abwechselnd hohem und niedrigem Brechungsindex und jeweils Dicken zwischen einschließlich 1 nm und 70 nm aufweist.

13. Optoelektronischer Halbleiterchip (1) nach einem der

vorhergehenden Ansprüche,
bei dem sich zwischen dem Träger (2) und der dem Träger (2) nächstgelegenen Mantelschicht (6n) eine hoch dotierte Schicht (7) befindet,
wobei eine Dotierstoffkonzentration der Schicht (7) zwischen einschließlich $1 \times 10^{18}$ pro $cm^3$ und $1 \times 10^{20}$ pro $cm^3$ und eine Dicke der Schicht (7) zwischen einschließlich 1 nm und 10 μm beträgt,
oder bei dem der Träger (2) eine solche Dotierstoffkonzentration aufweist.

14. Optoelektronischer Halbleiterchip (1) nach einem der
vorhergehenden Ansprüche,
bei dem die Wellenleiterschicht (5) und/oder die Mantelschicht (6n, 6p) einen gestuften Brechungsindexverlauf aufzeigen.

15. Optoelektronischer Halbleiterchip (1) nach einem der
vorhergehenden Ansprüche,
bei dem durch teilweises Entfernen der p-Mantelschicht (6p) ein Streifen (13) ausgebildet ist,
wobei der Streifen (13) in lateraler Richtung mindestens teilweise von einem Material mit einem niedrigeren Brechungsindex umgeben ist.

**Claims**

1. Optoelectronic semiconductor chip (1),
comprising a carrier (2) and a semiconductor layer sequence (3) which is mounted on the carrier and is based on a nitride compound semiconductor material having

- at least one active zone (4) which is designed for generating an electromagnetic radiation,
- at least one waveguide layer (5) which adjoins the active zone (4), wherein a waveguide (45) is formed, and
- a p-cladding layer (6p) which adjoins the waveguide layer (5) on a p-doped side and an n-cladding layer (6n) on an n-doped side of the active zone (4),

wherein

- at least the n-cladding layer (6n) is divided into at least two partial layers having different average aluminum contents,
- a first half (H1) of the n-cladding layer (6n) has a higher average aluminum content than a second half (H2) of the n-cladding layer (6n), wherein the halves (H1, H2) are of equal thickness, the halves (H1, H2) are a fictitious subdivision of the n-cladding layer (6n) and the first half (H1) is closer to the waveguide (45),
- the average aluminum content of the first half (H1) exceeds the mean aluminum content of the second half (H2) by at least 0.1 percentage points, and
- a mean refractive index of the n-cladding layer (6n) is smaller than a refractive index of the carrier (2), **characterized in that**
- an effective refractive index of a mode guided in the waveguide (45) is between the mean refractive index of the n-cladding layer (6n) and the mean refractive index of the waveguide (45),
- the effective refractive index of the mode guided in the waveguide (45) is greater than the refractive index of the carrier (2), and
- an evanescent field of the radiation which is totally reflected on the p-cladding layer (6p) or on the n-cladding layer (6N) and which is generated in the active zone (4) penetrates into the carrier (2) and an amplitude of the evanescent field in the carrier (2), in relation to a start amplitude at a total-reflecting interface, is at least 2.5% in places.

2. The optoelectronic semiconductor chip (1) according to the preceding claim,
in which a thickness of the n-cladding layer (6n) is at most 500 nm,
wherein an average aluminum content of the n-cladding layer (6n) is between 1% and 12% inclusive,
wherein the aluminum content in the n-cladding layer (6n) decreases in a direction away from the active zone (4),
and wherein the n-cladding layer (6n) has between 2 and 10 of the partial layers, and
wherein the partial layers have a monotonically increasing thickness in a direction away from the active zone (4).

3. The optoelectronic semiconductor chip (1) according to one of the preceding claims,

in which the effective refractive index of the mode guided in the waveguide (45) is at most 1.05 times the refractive index of the carrier (2).

4. The optoelectronic semiconductor chip (1) according to one of the preceding claims,
in which there is a hole barrier layer (10) in the n-cladding layer (6n) or between the n-cladding layer (6n) and the waveguide (45),
wherein a thickness of the hole barrier layer (10) is between 1 nm and 50 nm inclusive, and
wherein the hole barrier layer (10) has AlGaN as the base material with an aluminum content between 3% and 40% inclusive.

5. The optoelectronic semiconductor chip (1) according to one of the preceding claims,
in which the carrier (2) is a growth substrate on which the semiconductor layer sequence (3) is epitaxially grown,
wherein the waveguide layers (5n, 5p) and the cladding layers (6n, 6p) are designed in a stepped manner with regard to the refractive index profile thereof, and
wherein a partial layer of the p-cladding layer (6p) which lies closer to the active zone (4) has a smaller refractive index than a further partial layer of the p-cladding layer (6p) which is located further away from the active zone (4).

6. The optoelectronic semiconductor chip (1) according to one of the preceding claims,
in which the thickness ($T_p$) of the p-cladding layer is between 10 nm and 1500 nm inclusive.

7. The optoelectronic semiconductor chip (1) according to one of the preceding claims,
in which the p-cladding layer (6p) is based on one of the following materials:

$Al_xGa_{1-x}N$ with $0{,}0001 \leq x \leq 0{,}30$,
$Al_xIn_{1-x}N$ with $0{,}0001 \leq x \leq 0{,}90$, or
$(Al_{1-y}In_y)_xGa_{1-x}N$ with $0{,}0001 \leq y \leq 0{,}90$ and $0{,}0001 \leq x \leq 0{,}3$.

8. The optoelectronic semiconductor chip (1) according to one of the preceding claims,
in which the n-cladding layer (6n) is based on one of the following materials:

$Al_xGa_{1-x}N$ with $0{,}0001 \leq x \leq 0{,}30$,
$Al_xIn_{1-x}N$ with $0{,}0001 \leq x \leq 0{,}90$, or
$(Al_{1-y}In_y)_xGa_{1-x}N$ with $0{,}0001 \leq y \leq 0{,}90$ and $0{,}0001 \leq x \leq 0{,}3$ and/or in which the n-cladding layer (6n) is designed as a hole barrier.

9. The optoelectronic semiconductor chip (1) according to one of the preceding claims,
in which the active zone (3) has between 1 and 10 quantum wells inclusive,
wherein, in order to improve the waveguiding in the waveguide (45), there is a barrier layer based on $In_xGa_{1-x}N$ with $0.001 \leq x \leq 0.20$ and with a thickness of between 0.1 nm and 30 nm inclusive between at least two adjacent quantum wells.

10. The optoelectronic semiconductor chip (1) according to one of the preceding claims,
in which the waveguide layer (5) is a superlattice having layers (51, 52) with alternately high and low refractive indices and in each case thicknesses between 0.1 nm and 70 nm inclusive.

11. The optoelectronic semiconductor chip (1) according to the preceding claim,
in which the superlattice comprises alternating first layers (51), based on $In_{x1}Ga_{1-x1}N$ where $0{,}0001 \leq x \leq 0{,}10$, and second layers (52) based on $In_{x2}Ga_{1-x2}N$ with $0{,}0001 \leq x \leq 0.25$.

12. The optoelectronic semiconductor chip (1) according to one of the preceding claims,
in which the p-cladding layer (6p) comprises a superlattice having layers (51, 52) with alternately high and low refractive indices and in each case thicknesses between 1 nm and 70 nm inclusive.

13. The optoelectronic semiconductor chip (1) according to one of the preceding claims,
in which a highly doped layer (7) is located between the carrier (2) and the cladding layer (6n) closest to the carrier (2),
wherein a dopant concentration of the highly doped layer (7) is between $1 \times 10^{18}$ per $cm^3$ and $1 \times 10^{20}$ per $cm^3$ and a thickness of the highly doped layer (7) is between 1 nm and 10 $\mu$m inclusive,
or in which the carrier (2) has such a dopant concentration.

**14.** The optoelectronic semiconductor chip (1) according to one of the preceding claims,
in which the waveguide layer (5) and/or the cladding layer (6n, 6p) have a stepped refractive index profile.

**15.** The optoelectronic semiconductor chip (1) according to one of the preceding claims,
in which a strip (13) is formed by partially removing the p-cladding layer (6p),
wherein in the lateral direction the strip (13) is at least partially surrounded by a material having a lower refractive index.

**Revendications**

**1.** Puce à semi-conducteurs optoélectronique (1), comprenant un support (2) et une succession de couches semi-conductrices (3) basée sur un matériau semi-conducteur à composé de nitrure, apposée sur le support, avec

- au moins une zone active (4), prévue afin de générer un rayonnement électromagnétique,
- au moins une couche formant guide d'ondes (5), contiguë à la zone active (4), un guide d'ondes (45) étant constitué, et
- une couche de revêtement p (6p) contiguë à la couche formant guide d'ondes (5) sur un côté dopé p et une couche de revêtement n (6n) sur un côté dopé n de la zone active (4),
dans laquelle
- au moins la couche de revêtement n (6n) est divisée en au moins deux couches partielles avec des teneurs en aluminium moyennes différentes l'une de l'autre,
- une première moitié (H1) de la couche de revêtement n (6n) présente une teneur en aluminium moyenne supérieure à une deuxième moitié (H2) de la couche de revêtement n (6n), les moitiés (H1, H2) étant d'épaisseur identique, les moitiés (H1, H2) constituent uniquement une division fictive de la couche de revêtement n (6n) et la première moitié (H1) se trouvant plus près du guide d'ondes (45),
- la teneur en aluminium moyenne de la première moitié (H1) excède la teneur en aluminium moyenne de la deuxième moitié (H2) d'au moins 0,1 point de pourcentage, et
- l'indice de réfraction moyen de la couche de revêtement n (6n) est inférieur à l'indice de réfraction du support (2), **caractérisée en ce que**
- l'indice de réfraction effectif du mode mené dans le guide d'ondes (45) se situe entre un indice de réfraction moyen de la couche de revêtement n (6n) et l'indice de réfraction moyen du guide d'ondes (45),
- un indice de réfraction effectif d'un mode mené dans le guide d'ondes (45) est supérieur à un indice de réfraction du support (2), et
- un champ évanescent du rayonnement généré dans la zone active (4) et intégralement réfléchi sur la couche de revêtement p (6p) ou sur la couche de revêtement n (6n) atteint le support (2) et une amplitude du champ évanescent dans le support (2) atteint, par rapport à une amplitude de sortie sur une surface de séparation à réflexion totale, par endroits au moins 2,5 %.

**2.** Puce à semi-conducteurs optoélectronique (1) selon la revendication précédente, dans laquelle une épaisseur de la couche de revêtement n (6n) atteint au maximum 500 nm, une teneur en aluminium moyenne de la couche de revêtement n (6n) se trouvant entre y compris 1 % et 12 %, dans laquelle la teneur en aluminium au sein de la couche de revêtement n (6n) décroît dans une direction écartée de la zone active (4) et dans laquelle la couche de revêtement n (6n) présente entre y compris 2 et 10 des couches partielles, et dans laquelle les couches partielles présentent, dans une direction écartée de la zone active (4), une épaisseur à croissance monotone.

**3.** Puce à semi-conducteurs optoélectronique (1) selon l'une des revendications précédentes, dans laquelle l'indice de réfraction effectif du mode mené dans le guide d'ondes (45) atteint au maximum 1,05 fois l'indice de réfraction du support (2).

**4.** Puce à semi-conducteurs optoélectronique (1) selon l'une des revendications précédentes, dans laquelle une couche formant barrière et à orifices (10) se trouve dans la couche de revêtement n (6n) ou entre la couche de revêtement n (6n) et le guide d'ondes (45), dans laquelle une épaisseur de la couche formant barrière et à orifices (10) se situe entre 1 nm et 50 nm, et dans laquelle la couche formant barrière et à orifices (10) présente du AlGaN comme matériau de base avec une teneur en aluminium entre y compris 3 % et 40 %.

**5.** Puce à semi-conducteurs optoélectronique (1) selon l'une des revendications précédentes, dans laquelle le support (2) est un substrat de croissance sur lequel la succession de couches semi-conductrices (3) épitaxiale se trouve, dans laquelle les couches formant guide d'ondes (5n, 5p) ainsi que les couches de revêtement (6n, 6p) sont exécutées en échelonnement en ce qui concerne le tracé de leur indice de réfraction, et dans laquelle une couche partielle de la couche de revêtement p (6p), qui se trouve plus près de la zone active (4), présente un indice de réfraction plus faible qu'une autre couche partielle de la couche de revêtement p (6p) se trouvant plus à l'écart de la zone active (4).

6. Puce à semi-conducteurs optoélectronique (1) selon l'une des revendications précédentes, dans laquelle l'épaisseur (Tp) de la couche de revêtement p se situe entre y compris 10 nm et 1500 nm.

7. Puce à semi-conducteurs optoélectronique (1) selon l'une des revendications précédentes, dans laquelle la couche de revêtement p (6p) se fonde sur l'un des matériaux suivants :

   $Al_xGa_{1-x}N$ avec $0,0001 \leq x \leq 0,30$,
   $Al_xIn_{1-x}N$ avec $0,0001 \leq x \leq 0,90$, ou
   $(Al_{1-y}In_y)_xGa_{1-x}N$ avec $0,0001 \leq y \leq 0,90$ et $0,01 \leq x \leq 0,3$.

8. Puce à semi-conducteurs optoélectronique (1) selon l'une des revendications précédentes, dans laquelle la couche de revêtement n (6n) se fonde sur l'un des matériaux suivants :

   $Al_xGa_{1-x}N$ avec $0,0001 \leq x \leq 0,30$,
   $Al_xIn_{1-x}N$ avec $0,0001 \leq x \leq 0,90$, ou
   $(Al_{1-y}In_y)_xGa_{1-x}N$ avec $0,0001 \leq y \leq 0,90$ et $0,01 \leq x \leq 0,3$ et/ou dans laquelle la couche de revêtement n (6n) est aménagée sous forme de barrière à orifices.

9. Puce à semi-conducteurs optoélectronique (1) selon l'une des revendications précédentes, dans laquelle la zone active (3) présente entre y compris 1 et 10 films quantiques, une couche formant barrière à base de $In_xGa_{1-x}N$ avec $0,0001 \leq x \leq 0,20$ étant formée entre au moins deux films quantiques voisins afin d'améliorer le guidage d'ondes dans le guide d'ondes (45) et présentant une épaisseur entre y compris 0,1 nm et 30 nm.

10. Puce à semi-conducteurs optoélectronique (1) selon l'une des revendications précédentes, dans laquelle la couche formant guide d'ondes (5) présente un super-réseau avec des couches (51, 52) présentant un indice de réfraction tour à tour élevé et faible et respectivement des épaisseurs entre y compris 0,1 nm et 70 nm.

11. Puce à semi-conducteurs optoélectronique (1) selon la revendication précédente, dans laquelle le super-réseau présente tour à tour de premières couches (51), basées sur $In_{x1}Ga_{1-x1}N$ avec $0 \leq xi \leq 0, 10$, et de deuxièmes couches (52), basées sur $In_{x2}Ga_{1-x2}N$ avec $0,01$ $0,0001 \leq x \leq 0,25$.

12. Puce à semi-conducteurs optoélectronique (1) selon l'une des revendications précédentes, dans laquelle la couche de revêtement p (6p) présente un super-réseau avec des couches (51, 52) présentant un indice de réfraction tour à tour élevé et faible et respectivement des épaisseurs entre y compris 1 nm et 70 nm.

13. Puce à semi-conducteurs optoélectronique (1) selon l'une des revendications précédentes, dans laquelle une couche hautement dopée (7) se trouve entre le support (2) et la couche de revêtement (6n) la plus proche du support (2), dans laquelle une concentration en dopant de la couche (7) se situe entre y compris $1 \times 10^{18}$ par $cm^3$ et $1 \times 10^{20}$ par $cm^3$ et une épaisseur de la couche (7) entre y compris 1 nm et 10 $\mu$m, ou dans laquelle le support (2) présente une telle concentration en dopant.

14. Puce à semi-conducteurs optoélectronique (1) selon l'une des revendications précédentes, dans laquelle la couche formant guide d'ondes (5) et/ou la couche de revêtement (6n, 6p) présentent un tracé d'indice de réfraction échelonné.

15. Puce à semi-conducteurs optoélectronique (1) selon l'une des revendications précédentes, dans laquelle le retrait partiel de la couche de revêtement p (6p) crée une bande (13), la bande (13) étant au moins partiellement entourée par un matériau à moindre indice de réfraction dans le sens latéral.

## FIG 1

A)

B)

# FIG 2

A)

B)

## FIG 3

A)

B)

## FIG 4

A)

B)

# FIG 5

# FIG 6

A)

B)

FIG 7

A)

B)

## FIG 8

A)

B)

# FIG 9

A)

B)

## FIG 10

## FIG 11

A)

B)

# FIG 12

A)

B)

# FIG 13

A)

B)

# FIG 14

A)

B)

# FIG 15

A)

B)

## FIG 16

A)

B)

## FIG 17

A)

B)

**FIG 17**

C)

FIG 18

A)

B)

C)

## FIG 19

A)

B)

FIG 20

# FIG 21

A)

B)

FIG 22

A)

B)

## FIG 23

## FIG 24

|    | K(L1)    | d (L1) | K(L2) | d (L2) | K(L3) | d (L3) | K(L4) | d (L4) | $K_a$(H1) | $K_a$(H2) |
|----|----------|--------|-------|--------|-------|--------|-------|--------|-----------|-----------|
| 1  | 8%       | 400nm  | 5%    | 1600nm |       |        |       |        | 6,2%      | 5%        |
| 2  | 7%       | 400nm  | 4,5%  | 1600nm |       |        |       |        | 5,5%      | 4,5%      |
| 3  | 6%       | 400nm  | 4%    | 1600nm |       |        |       |        | 4,8%      | 4%        |
| 4  | 6%       | 400nm  | 2%    | 1600nm |       |        |       |        | 3,6%      | 2%        |
| 5  | 5%       | 100nm  | 4%    | 200nm  | 3%    | 300nm  | 2%    | 1400nm | 3%        | 2%        |
| 6  | 2%       | 50nm   | 5%    | 100nm  | 4%    | 300nm  | 2%    | 1550nm | 2,9%      | 2%        |
| 7  | 1%       | 50nm   | 8%    | 400nm  | 4%    | 1550nm |       |        | 5,5%      | 4%        |
| 8  | 8%       | 100nm  | 6%    | 300nm  | 4%    | 1600nm |       |        | 5%        | 4%        |
| 9  | 8%→ 5%   | 600nm  | 5%    | 1400nm |       |        |       |        | 5,9%      | 5%        |
| 10 | 5%→ 8%   | 600nm  | 5%    | 1400nm |       |        |       |        | 5,9%      | 5%        |

EP 2 539 980 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20050226295 A1
- US 20020039374 A1